# EUROPEAN PATENT APPLICATION

(11) **EP 4 704 072 A1**
(43) Date of publication of application: **04.03.2026**
(21) Application number: 24795665.9
(22) Date of filing: 14.03.2024
(51) Int. Cl.: G09G 3/3266, G11C 19/28, G09G 3/20

(54) **DRIVING CIRCUIT, DRIVING METHOD, DISPLAY SUBSTRATE AND DISPLAY APPARATUS**

(30) Priority: 26.04.2023 CN 202310466808
(71) Applicant: Boe Technology Group Co., Ltd., Beijing 100015 (CN); Beijing BOE Technology Development Co., Ltd., Beijing 100176 (CN)
(72) Inventor: LV, Guangshuang, Beijing 100176 (CN); XU, Pan, Beijing 100176 (CN); HAN, Ying, Beijing 100176 (CN); LUO, Chengyuan, Beijing 100176 (CN); ZHANG, Xing, Beijing 100176 (CN); ZHAO, Donghui, Beijing 100176 (CN); XU, Cheng, Beijing 100176 (CN); LIU, Miao, Beijing 100176 (CN); YAO, Xing, Beijing 100176 (CN)
(74) Representative: Isarpatent
(86) International application number: PCT/CN2024/081552
(87) International publication number: WO 2024/222282

(57) **Abstract**

A driving circuit, a driving method, a display substrate and a display device are provided. The driving circuit includes N driving output terminals, a first node control circuit, a second node control circuit and a driving output circuit; the first node control circuit is electrically connected to the first node, and is configured to control the potential of the first node; the second node control circuit is electrically connected to the second node, and is configured to control the potential of the second node; the driving output circuit is electrically connected to the first node, the second node and the N driving output terminals respectively, and is configured to control the n-th driving output terminal to output the n-th driving signal under the control of the potential of the first node and the potential of the second node; N is an integer greater than 1; n is a positive integer less than or equal to N. The present invention controls multiple rows of pixel circuits to share a driving circuit, a first node and a second node, so as to increase the longitudinal space, reduce the lateral space and save the border.

## Description

### CROSS REFERENCE OF RELATED APPLICATION

The present disclosure claims a priority of Chinese patent disclosure No. 202310466808.8 filed on April 26, 2023, which is incorporated herein by reference in its entirety.

### TECHNICAL FIELD

The present disclosure relates to the field of display technology, and in particular to a driving circuit, a driving method, a display substrate and a display device.

### BACKGROUND

In the related art, display technology is increasingly pursuing high PPI (Pixels Per Inch, pixel density) display, and ultra-high-resolution display can significantly improve the display effect of the display. However, it also brings many design problems, and drive circuit design is one of them. The number of rows of driving circuits corresponding to ultra-high-resolution displays also needs to increase. Taking a 30-inch 4K display product as an example, in a conventional drive circuit layout design, each row of pixels corresponds to a row of drive circuits. The vertical space of a row of drive circuits only occupies 50 µm, which is only high enough to accommodate transistors, and cannot achieve signals. Connected design will increase horizontal space and increase borders.

### SUMMARY

In one aspect, an embodiment of the present disclosure provides a driving circuit including N driving output terminals, a first node control circuit, a second node control circuit and a driving output circuit;

The first node control circuit is electrically connected to the first node and is configured to control the potential of the first node;

The second node control circuit is electrically connected to the second node and is configured to control the potential of the second node;

The driving output circuit is electrically connected to the first node, the second node and N driving output terminals respectively, and is configured to control the n-th driving output terminal to output the n-th driving signal under the control of the potential of the first node and the potential of the second node;

N is an integer greater than 1; n is a positive integer less than or equal to N.

Optionally, the driving output circuit includes N driving output units; N is an integer greater than 1;

The n-th driving output unit is electrically connected to the first node, the second node and the n-th driving output terminal respectively, and is configured to control the n-th driving output terminal to output the n-th driving signal under the control of the potential of the first node and the potential of the second node;
n is a positive integer less than or equal to N.

Optionally, the n-th driving output unit includes an n-th output circuit and an n-th output reset circuit;

The n-th output circuit is electrically connected to the first node, the n-th first voltage terminal and the n-th driving output terminal respectively, and is configured to control the connection between the n-th driving output terminal and the n-th first voltage terminal under the control of the potential of the first node;

The n-th output reset circuit is electrically connected to the second node, the n-th second voltage terminal and the n-th driving output terminal respectively, and is configured to control the connection between the n-th driving output terminal and the n-th second voltage terminal under the control of the potential of the second node.

Optionally, the first voltage terminals to which the N driving output units are respectively electrically connected are the same; and/or,

The N driving output units are respectively electrically connected to the same second voltage terminal.

Optionally, the n-th output reset circuit includes an n-th first output reset sub-circuit and an n-th second output reset sub-circuit;

The n-th first output reset sub-circuit is electrically connected to the second node, the n-th driving output terminal and the n-th output node respectively, and is configured to control the n-th driving output terminal to be electrically connected to the n-th output node under the control of the potential of the second node;

The n-th second output reset sub-circuit is electrically connected to the second node, the n-th output node and the n-th second voltage terminal respectively, and is configured to control the connection between the n-th output node and the n-th second voltage terminal under the control of the potential of the second node;

The n-th driving output unit also includes an n-th setting circuit;

The n-th setting circuit is electrically connected to the n-th driving output terminal, the n-th output node and the third voltage terminal respectively, and is configured to control the connection between the n-th output node and the third voltage terminal under the control of the n-th driving signal provided by the n-th driving output terminal.

Optionally, the driving circuit described in at least one embodiment of the present disclosure further includes a first energy storage circuit;

A first terminal of the first energy storage circuit is electrically connected to the first node, a second terminal of the first energy storage circuit is electrically connected to one of the N driving output terminals, and the first energy storage circuit is configured to store electrical energy.

Optionally, the driving circuit described in at least one embodiment of the present disclosure further includes at least two first energy storage circuits;

The first terminals of the at least two first energy storage circuits are electrically connected to the first node, the second terminals of the at least two first energy storage circuits are electrically connected to at least two of the driving output terminals respectively, and the first energy storage circuits are configured to store electrical energy.

Optionally, the driving circuit described in at least one embodiment of the present disclosure further includes a second energy storage circuit;

The second energy storage circuit is electrically connected to the second node, and the second energy storage circuit is configured to store electrical energy.

Optionally, a control terminal of the n-th output reset circuit is electrically connected to the second node, a first terminal of the n-th output reset circuit is electrically connected to the n-th driving output terminal, and a second terminal of the n-th output reset circuit is electrically connected to the n-th second voltage terminal;

The driving circuit further includes at least two second energy storage circuits;

The first terminal of the second energy storage circuit is electrically connected to the second node, and the second terminal of the second energy storage circuit is electrically connected to the second terminal of one of the N output reset circuits; the second energy storage circuit is configured to store electrical energy.

Optionally, the n-th output circuit includes an n-th output transistor, and the n-th output reset circuit includes an n-th output reset transistor;
electrode of the n-th output transistor is electrically connected to the n-th first voltage terminal, and the second electrode of the n-th output transistor is electrically connected to the n-th driving output terminal;
electrode of the n-th output reset transistor is electrically connected to the n-th driving output terminal, and the second electrode of the n-th output reset transistor is electrically connected to the n-th second voltage terminal.

Optionally, the n-th first output reset sub-circuit includes an n-th first output reset transistor, the n-th second output reset sub-circuit includes an n-th second output reset transistor, and the n-th setting circuit includes an n-th setting transistor;
the n-th first output reset transistor is electrically connected to the second node, the first electrode of the n-th first output reset transistor is electrically connected to the n-th driving output terminal, and the second electrode of the n-th first output reset transistor is electrically connected to the n-th output node;
the n-th second output reset transistor is electrically connected to the second node, the first electrode of the n-th second output reset transistor is electrically connected to the n-th output node, and the second electrode of the n-th second output reset transistor is electrically connected to the n-th second voltage terminal;

The gate of the n-th setting transistor is electrically connected to the n-th driving output terminal, the first electrode of the n-th setting transistor is electrically connected to the n-th output node, and the second electrode of the n-th setting transistor is electrically connected to the third voltage terminal.

Optionally, the driving output circuit includes an output transistor and an output reset transistor;

The gate of the output transistor is electrically connected to the first node, the first electrode of the output transistor is electrically connected to the first voltage terminal, and the second electrode of the output transistor is electrically connected to the N driving output terminals respectively;
is electrically connected to the N driving output terminals respectively, and the second electrode of the output reset transistor is electrically connected to the second voltage terminal.

Optionally, the first node control circuit is also electrically connected to the first clock signal terminal, the input terminal, the third node, the fourth voltage terminal, the fifth voltage terminal and the reset terminal, respectively, and is configured to control the connection between the first node and the fourth voltage terminal under the control of the first clock signal provided by the first clock signal terminal and the input signal provided by the input terminal, control the connection between the first node and the first clock signal terminal under the control of the reset signal provided by the reset terminal, and control the connection between the first node and the fifth voltage terminal under the control of the potential of the third node and the first clock signal.

Optionally, the first node control circuit is also electrically connected to the intermediate node, the first clock signal terminal, the input terminal, the third node, the fourth voltage terminal, the fifth voltage terminal and the reset terminal, respectively, and is configured to control the connection between the intermediate node and the fourth voltage terminal under the control of the first clock signal provided by the first clock signal terminal and the input signal provided by the input terminal, control the connection between the intermediate node and the first clock signal terminal under the control of the reset signal provided by the reset terminal, control the connection between the intermediate node and the fifth voltage terminal under the control of the potential of the third node and the first clock signal, and control the connection between the intermediate node and the first node under the control of the fourth voltage signal provided by the fourth voltage terminal.

Optionally, the driving circuit further includes a third node control circuit and a carry output circuit;

The third node control circuit is electrically connected to the third node and is configured to control the potential of the third node;

The second node control circuit is also electrically connected to the third node, the first clock signal terminal, the first node, the fourth node and the fifth voltage terminal, respectively, and is configured to control the second node to be connected to the fourth node under the control of the first clock signal, control the fourth node to be connected to the second node under the control of the first clock signal, and control the second node to be connected to the fifth voltage terminal under the control of the potential of the first node;

The carry output circuit is electrically connected to the first node, the second node, the carry output terminal, the first voltage terminal and the fifth voltage terminal, respectively, and is configured to control the connection between the carry output terminal and the first voltage terminal under the control of the potential of the first node, and to control the connection between the carry output terminal and the fifth voltage terminal under the control of the potential of the second node.

Optionally, the second node control circuit is also electrically connected to the reset terminal and the fourth voltage terminal, respectively, and is configured to control the connection between the second node and the fourth voltage terminal under the control of a reset signal provided by the reset terminal.

Optionally, the third node control circuit is also electrically connected to the second clock signal terminal, the fourth voltage terminal, the input terminal, the fourth node and the fifth node, respectively, and is configured to control the connection between the third node and the fourth voltage terminal under the control of the second clock signal provided by the second clock signal terminal, control the connection between the third node and the fifth node under the control of the input signal provided by the input terminal, control the connection between the fifth node and the second clock signal terminal, control the connection between the fifth node and the fourth voltage terminal under the control of the potential of the third node, and control the potential of the third node according to the potential of the fourth node.

Optionally, the first node control circuit includes a first transistor, a second transistor, a third transistor, a fourth transistor and a fifth transistor;
electrode of the first transistor is electrically connected to the fourth voltage terminal, and the second electrode of the first transistor is electrically connected to the first electrode of the second transistor;

The gate of the second transistor is electrically connected to the input terminal, and the second electrode of the second transistor is electrically connected to the first node;

The gate of the third transistor is electrically connected to the third node, the first electrode of the third transistor is electrically connected to the first node, and the second electrode of the third transistor is electrically connected to the first electrode of the fourth transistor;

The gate of the fourth transistor is electrically connected to the first clock signal terminal, and the second electrode of the fourth transistor is electrically connected to the fifth voltage terminal;

A gate of the fifth transistor is electrically connected to the reset terminal, a first electrode of the fifth transistor is electrically connected to the first clock signal terminal, and a second electrode of the fifth transistor is electrically connected to the first node.

Optionally, the first node control circuit includes a first transistor, a second transistor, a third transistor, a fourth transistor, a fifth transistor and a sixth transistor;
electrode of the first transistor is electrically connected to the fourth voltage terminal, and the second electrode of the first transistor is electrically connected to the first electrode of the second transistor;

The gate of the second transistor is electrically connected to the input terminal, and the second electrode of the second transistor is electrically connected to the intermediate node;

The gate of the third transistor is electrically connected to the third node, the first electrode of the third transistor is electrically connected to the intermediate node, and the second electrode of the third transistor is electrically connected to the first electrode of the fourth transistor;

The gate of the fourth transistor is electrically connected to the first clock signal terminal, and the second electrode of the fourth transistor is electrically connected to the fifth voltage terminal;

The gate of the fifth transistor is electrically connected to the reset terminal, the first electrode of the fifth transistor is electrically connected to the first clock signal terminal, and the second electrode of the fifth transistor is electrically connected to the intermediate node.

A gate of the sixth transistor is electrically connected to the fourth voltage terminal, a first electrode of the sixth transistor is electrically connected to the intermediate node, and a second electrode of the sixth transistor is electrically connected to the first node.

Optionally, the second node control circuit includes a seventh transistor, an eighth transistor and a ninth transistor;

The gate of the seventh transistor is electrically connected to the third node, the first electrode of the seventh transistor is electrically connected to the first clock signal terminal, and the second electrode of the seventh transistor is electrically connected to the fourth node;

The gate of the eighth transistor is electrically connected to the first clock signal terminal, the first electrode of the eighth transistor is electrically connected to the fourth node, and the second electrode of the eighth transistor is electrically connected to the second node;

A gate of the ninth transistor is electrically connected to the first node, a first electrode of the ninth transistor is electrically connected to the second node, and a second electrode of the ninth transistor is electrically connected to the fifth voltage terminal.

Optionally, the second node control circuit further includes a tenth transistor;

A gate of the tenth transistor is electrically connected to the reset terminal, a first electrode of the tenth transistor is electrically connected to the second node, and a second electrode of the tenth transistor is electrically connected to the fourth voltage terminal.

Optionally, the third node control circuit includes an eleventh transistor, a twelfth transistor, a thirteenth transistor, a fourteenth transistor and a third capacitor;

The gate of the eleventh transistor is electrically connected to the second clock signal terminal, the first electrode of the eleventh transistor is electrically connected to the fourth voltage terminal, and the second electrode of the eleventh transistor is electrically connected to the third node;

The gate of the twelfth transistor is electrically connected to the input terminal, the first electrode of the twelfth transistor is electrically connected to the third node, and the second electrode of the twelfth transistor is electrically connected to the fifth node;

The gate of the thirteenth transistor is electrically connected to the input terminal, the first electrode of the thirteenth transistor is electrically connected to the fifth node, and the second electrode of the thirteenth transistor is electrically connected to the second clock signal terminal;

The gate of the fourteenth transistor is electrically connected to the third node, the first electrode of the fourteenth transistor is electrically connected to the fourth voltage terminal, and the second electrode of the fourteenth transistor is electrically connected to the fifth node;

The first electrode plate of the third capacitor is electrically connected to the third node, and the second electrode plate of the third capacitor is electrically connected to the fourth node.

Optionally, the carry output circuit includes a fifteenth transistor and a sixteenth transistor;

The gate of the fifteenth transistor is electrically connected to the first node, the first electrode of the fifteenth transistor is electrically connected to the first voltage terminal, and the second electrode of the fifteenth transistor is electrically connected to the carry output terminal;

A gate of the sixteenth transistor is electrically connected to the second node, a first electrode of the sixteenth transistor is electrically connected to the carry output terminal, and a second electrode of the sixteenth transistor is electrically connected to the fifth voltage terminal.

Optionally, the first energy storage circuit includes a first capacitor;

The first electrode plate of the first capacitor is electrically connected to the first node, and the second electrode plate of the first capacitor is electrically connected to one of the N driving output terminals.

Optionally, the driving circuit includes N first energy storage circuits, and the n-th first energy storage circuit includes an n-th first capacitor;
the n-th first capacitor is electrically connected to the first node, and the second electrode plate of the n-th first capacitor is electrically connected to the n-th driving output terminal.

Optionally, the second energy storage circuit includes a second capacitor;

The first electrode plate of the second capacitor is electrically connected to the second node, and the second electrode plate of the second capacitor is electrically connected to the second terminal of one of the N output reset circuits.

Optionally, the driving circuit includes N second energy storage circuits; the n-th second energy storage circuit includes an n-th second capacitor;
the n-th second capacitor is electrically connected to the second node, and the second electrode plate of the n-th second capacitor is electrically connected to the second terminal of the n-th output reset circuit.

In a second aspect, an embodiment of the present disclosure provides a driving method, which is applied to the above-mentioned driving circuit, and the driving method includes:
A first node control circuit controls the potential of the first node;
The second node control circuit controls the potential of the second node;
to output the n-th driving signal under the control of the potential of the first node and the potential of the second node;
N is an integer greater than 1; n is a positive integer less than or equal to N.

In a third aspect, an embodiment of the present disclosure provides a display substrate, comprising the above-mentioned driving circuit.

Optionally, the driving circuit includes a second energy storage circuit; the second energy storage circuit is electrically connected to the second node, and the second energy storage circuit is configured to store electric energy; the second energy storage circuit includes a second capacitor; and the display substrate further includes N-1 pseudo capacitors;

The second capacitor and the N-1 pseudo capacitors are arranged along a first direction

The first electrode plate of the pseudo capacitor is electrically connected to the second electrode plate of the pseudo capacitor.

In a fourth aspect, an embodiment of the present disclosure provides a display device, comprising the above-mentioned driving circuit.

### BRIEF DESCRIPTION OF THE DRAWINGS

FIG.1 is a structural diagram of a driving circuit according to at least one embodiment of the present disclosure;
FIG.2 is a structural diagram of a driving circuit according to at least one embodiment of the present disclosure;
FIG.3 is a structural diagram of a driving circuit according to at least one embodiment of the present disclosure;
FIG.4 is a structural diagram of a driving circuit according to at least one embodiment of the present disclosure;
FIG.5 is a structural diagram of a driving circuit according to at least one embodiment of the present disclosure;
FIG.6 is a structural diagram of a driving circuit according to at least one embodiment of the present disclosure;
FIG.7 is a structural diagram of a driving circuit according to at least one embodiment of the present disclosure;
FIG.8 is a structural diagram of a driving circuit according to at least one embodiment of the present disclosure;
FIG.9 is a structural diagram of a driving circuit according to at least one embodiment of the present disclosure;
FIG.10 is a structural diagram of a driving circuit according to at least one embodiment of the present disclosure;
FIG.11 is a structural diagram of a driving circuit according to at least one embodiment of the present disclosure;
FIG.12 is a structural diagram of a driving circuit according to at least one embodiment of the present disclosure;
FIG.13 is a structural diagram of a driving circuit according to at least one embodiment of the present disclosure;
FIG.14 is a structural diagram of a driving circuit according to at least one embodiment of the present disclosure;
FIG.15 is a structural diagram of a driving circuit according to at least one embodiment of the present disclosure;
FIG.16 is a circuit diagram of a driving circuit according to at least one embodiment of the present disclosure;
FIG.17 is a timing diagram of operation of at least one embodiment of the driving circuit shown in FIG.16;
FIG. 18 is a circuit diagram of at least one embodiment of a pixel circuit;
FIG.19 is an operation timing diagram of at least one embodiment of the pixel circuit shown in FIG.18;
FIG.20 is a circuit diagram of a driving circuit according to at least one embodiment of the present disclosure;
FIG.21 is a timing diagram of operation of at least one embodiment of the driving circuit shown in FIG.20;
FIG.22 is a waveform diagram of each scanning signal, each light emitting control signal and each data voltage;
FIG.23 is a circuit diagram of a driving circuit according to at least one embodiment of the present disclosure;
FIG.24 is a circuit diagram of a driving circuit according to at least one embodiment of the present disclosure;
FIG.25 is a simulation work time sequence diagram in one embodiment of the driving circuit shown in FIG.16 when the width-to-length ratio of each output transistor is the first width-to-length ratio A1 and the width-to-length ratio of each output reset transistor is the second width-to-length ratio A2;
FIG.26 is a simulation work time sequence diagram in one embodiment of the driving circuit shown in FIG.24 when the width-to-length ratio of the output transistor is the first width-to-length ratio A1 and the width-to-length ratio of the output reset transistor is the second width-to-length ratio A2;
FIG.27 is a simulation work time sequence diagram in one embodiment of the driving circuit shown in FIG.24 when the width-to-length ratio of the output transistor is 4×A1 and the width-to-length ratio of the output reset transistor is 4×A2;
FIG.28 is a schematic diagram showing the relationship between the channel width W of the output reset transistor and the falling time Tf of the driving signal;
FIG.29 is a layout diagram of at least one embodiment of the driving circuit shown in FIG.16; and
FIG. 30 is an enlarged schematic diagram of the first area in FIG. 29.

### DETAILED DESCRIPTION

The following will be combined with the drawings in the embodiments of the present disclosure to clearly and completely describe the technical solutions in the embodiments of the present disclosure. Obviously, the described embodiments are only part of the embodiments of the present disclosure, rather than all the embodiments. Based on the embodiments in the present disclosure, all other embodiments obtained by ordinary technicians in this field without making creative work are within the scope of protection of the present disclosure.

The transistor of the present disclosure may be thin film transistors or field effect transistors or other devices with the same characteristics. In the embodiments of the present disclosure, in order to distinguish the two electrodes of the transistor except the gate, one of the electrodes is called the first electrode and the other is called the second electrode.

In actual operation, when the transistor is a thin film transistor or a field effect transistor, the first electrode may be a drain electrode, and the second electrode may be a source electrode; or, the first electrode may be a source electrode, and the second electrode may be a drain electrode.

The driving circuit described in the embodiment of the present disclosure includes N driving output terminals, a first node control circuit, a second node control circuit and a driving output circuit;

The first node control circuit is electrically connected to the first node and is configured to control the potential of the first node;

The second node control circuit is electrically connected to the second node and is configured to control the potential of the second node;

The driving output circuit is electrically connected to the first node, the second node and N driving output terminals respectively, and is configured to control the n-th driving output terminal to output the n-th driving signal under the control of the potential of the first node and the potential of the second node;

N is an integer greater than 1; n is a positive integer less than or equal to N.

In the related technologies, display technology is increasingly pursuing high PPI (Pixels Per Inch, pixel density) display, and ultra-high-resolution display can significantly improve the display effect of the display. However, it also brings many design problems, and drive circuit design is one of them. The number of rows of driving circuits corresponding to ultra-high-resolution displays also needs to increase. Taking a 30-inch 4K display product as an example, in a conventional drive circuit layout design, each row of pixels corresponds to a row of drive circuits. The vertical space of a row of drive circuits only occupies 50 µm, which is only high enough to accommodate transistors, and cannot achieve signals. Connected design will increase horizontal space and increase borders. In response to the above problems, embodiments of the present disclosure provide a driving circuit. Multiple rows of pixel circuits share a driving circuit, share the first node and the second node, increase vertical space, reduce horizontal space, and save borders.

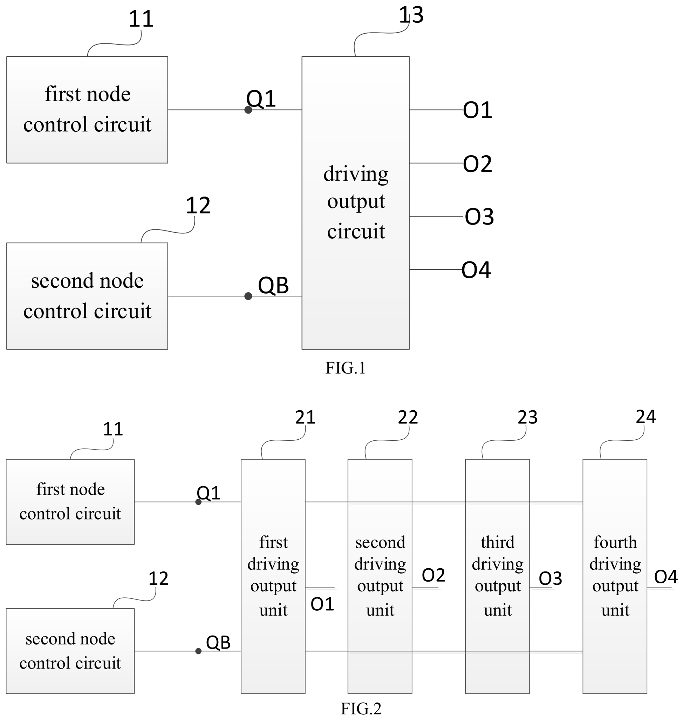

As shown in FIG. 1, the driving circuit according to at least one embodiment of the present disclosure includes a first driving output terminal O1, a second driving output terminal O2, a third driving output terminal O3, a fourth driving output terminal O4, a first node control circuit 11, a second node control circuit 12 and a driving output circuit 13;

The first node control circuit 11 is electrically connected to the first node Q1 and is configured to control the potential of the first node Q;

The second node control circuit 12 is electrically connected to the second node QB and is configured to control the potential of the second node;

The driving output circuit is electrically connected to the first node Q1, the second node QB, the first driving output terminal O1, the second driving output terminal O2, the third driving output terminal O3 and the fourth driving output terminal O4, respectively, and is configured to control the first driving output terminal O1 to output a first drive signal, control the second driving output terminal O2 to output a second drive signal, control the third driving output terminal O3 to output a third drive signal, and control the fourth driving output terminal O4 to output a fourth drive signal under the control of the potential of the first node Q1 and the potential of the second node QB.

In at least one embodiment of the present disclosure, the driving output circuit includes N driving output units; N is an integer greater than 1;

The n-th driving output unit is electrically connected to the first node, the second node and the n-th driving output terminal respectively, and is configured to control the n-th driving output terminal to output the n-th driving signal under the control of the potential of the first node and the potential of the second node;
n is a positive integer less than or equal to N.

In a specific implementation, the driving output circuit may include N driving output units, the N driving output units share a first node and a second node, and the n-th driving output unit controls the n-th driving output terminal to output the n-th drive signal under the control of the potential of the first node and the potential of the second node, so as to save the number of transistors used in the drive circuit.

As shown in Fig.2, based on one embodiment of the driving circuit shown in FIG. 1, the driving output circuit includes a first driving output unit 21, a second driving output unit 22, a third driving output unit 23 and a fourth driving output unit 24;

The first driving output unit 21 is electrically connected to the first node Q1, the second node QB and the first driving output terminal O1 respectively, and is configured to control the first driving output terminal O1 to output the first driving signal under the control of the potential of the first node Q1 and the potential of the second node QB;

The second driving output unit 22 is electrically connected to the first node Q1, the second node QB and the second driving output terminal O2 respectively, and is configured to control the second driving output terminal O2 to output a second driving signal under the control of the potential of the first node Q1 and the potential of the second node QB;

The third driving output unit 23 is electrically connected to the first node Q1, the second node QB and the third driving output terminal O3 respectively, and is configured to control the third driving output terminal O3 to output a third driving signal under the control of the potential of the first node Q1 and the potential of the second node QB;

The fourth driving output unit 24 is electrically connected to the first node Q1, the second node QB and the fourth driving output terminal O4 respectively, and is configured to control the fourth driving output terminal O4 to output a fourth driving signal under the control of the potential of the first node Q1 and the potential of the second node QB.

In at least one embodiment of the present disclosure, the n-th driving output unit includes an n-th output circuit and an n-th output reset circuit;

The n-th output circuit is electrically connected to the first node, the n-th first voltage terminal and the n-th driving output terminal respectively, and is configured to control the connection between the n-th driving output terminal and the n-th first voltage terminal under the control of the potential of the first node;

The n-th output reset circuit is electrically connected to the second node, the n-th second voltage terminal and the n-th driving output terminal respectively, and is configured to control the connection between the n-th driving output terminal and the n-th second voltage terminal under the control of the potential of the second node.

Optionally, the first voltage terminals to which the N driving output units are respectively electrically connected are the same; and/or,

The N driving output units are respectively electrically connected to the same second voltage terminal.

In a specific implementation, the first voltage terminals to which the N driving output units are respectively electrically connected may be the same, and/or the second voltage terminals to which the N driving output units are respectively electrically connected may be the same;

The first voltage terminal may be a high voltage terminal, and the second voltage terminal may be a second low voltage terminal, but is not limited thereto.

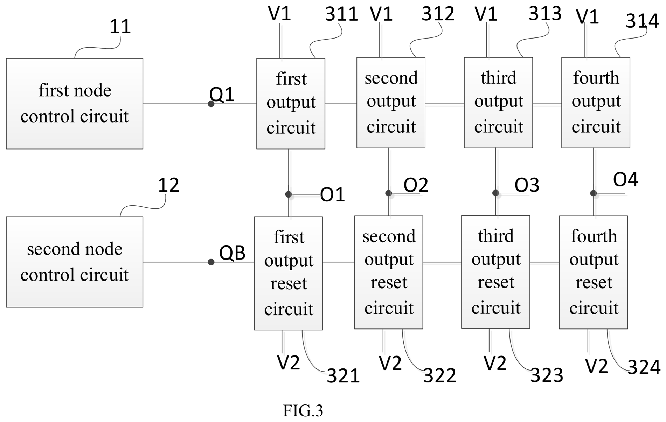

As shown in Fig.3, based on one embodiment of the driving circuit shown in FIG. 2, the first driving output unit includes a first output circuit 311 and a first output reset circuit 321;

The first output circuit 311 is electrically connected to the first node Q1, the first voltage terminal V1 and the first driving output terminal O1 respectively, and is configured to control the connection between the first driving output terminal O1 and the first voltage terminal V1 under the control of the potential of the first node Q1;

The first output reset circuit 321 is electrically connected to the second node QB, the second voltage terminal V2 and the first driving output terminal O1, respectively, for controlling the first driving output terminal O1 to be connected to the second voltage terminal V2 under the control of the potential of the second node QB;

The second driving output unit includes a second output circuit 312 and a second output reset circuit 322;

The second output circuit 312 is electrically connected to the first node Q1, the first voltage terminal V1 and the second driving output terminal O2 respectively, and is configured to control the second driving output terminal O2 to be connected to the first voltage terminal V1 under the control of the potential of the first node Q1;

The second output reset circuit 322 is electrically connected to the second node QB, the second voltage terminal V2 and the second driving output terminal O2, respectively, for controlling the second driving output terminal O2 to be connected to the second voltage terminal V2 under the control of the potential of the second node QB;

The third driving output unit includes a third output circuit 313 and a third output reset circuit 323;

The third output circuit 313 is electrically connected to the first node Q1, the first voltage terminal V1 and the second driving output terminal O2 respectively, and is configured to control the connection between the third driving output terminal O3 and the first voltage terminal V1 under the control of the potential of the first node Q1;

The third output reset circuit 323 is electrically connected to the second node QB, the second voltage terminal V2 and the second driving output terminal O2, respectively, for controlling the third driving output terminal O3 and the second voltage terminal V2 to be connected under the control of the potential of the second node QB;

The fourth driving output unit includes a fourth output circuit 314 and a fourth output reset circuit 324;

The fourth output circuit 314 is electrically connected to the first node Q1, the first voltage terminal V1 and the fourth driving output terminal O4 respectively, and is configured to control the fourth driving output terminal O4 to be connected to the first voltage terminal V1 under the control of the potential of the first node Q1;

The fourth output reset circuit 324 is electrically connected to the second node QB, the second voltage terminal V2 and the fourth driving output terminal O4 respectively, and is configured to control the connection between the fourth driving output terminal O4 and the second voltage terminal V2 under the control of the potential of the second node QB.

In at least one embodiment of the present disclosure, the n-th output reset circuit includes an n-th first output reset sub-circuit and an n-th second output reset sub-circuit;

The n-th first output reset sub-circuit is electrically connected to the second node, the n-th driving output terminal and the n-th output node respectively, and is configured to control the n-th driving output terminal to be electrically connected to the n-th output node under the control of the potential of the second node;

The n-th second output reset sub-circuit is electrically connected to the second node, the n-th output node and the n-th second voltage terminal respectively, and is configured to control the connection between the n-th output node and the n-th second voltage terminal under the control of the potential of the second node;

The n-th driving output unit also includes an n-th setting circuit;

The n-th setting circuit is electrically connected to the n-th driving output terminal, the n-th output node and the third voltage terminal respectively, and is configured to control the connection between the n-th output node and the third voltage terminal under the control of the n-th driving signal provided by the n-th driving output terminal.

Optionally, the third voltage terminal may be a high voltage terminal, but is not limited thereto.

In a specific implementation, the n-th output reset circuit may include an n-th first output reset sub-circuit and an n-th second output reset sub-circuit, and the n-th driving output unit may also include an n-th set circuit, which, under the control of the n-th drive signal, controls the connection between the n-th output node and the third voltage terminal, so that when the n-th driving output terminal outputs a valid n-th driving output signal, the potential of the n-th driving output terminal will not be reduced due to leakage.

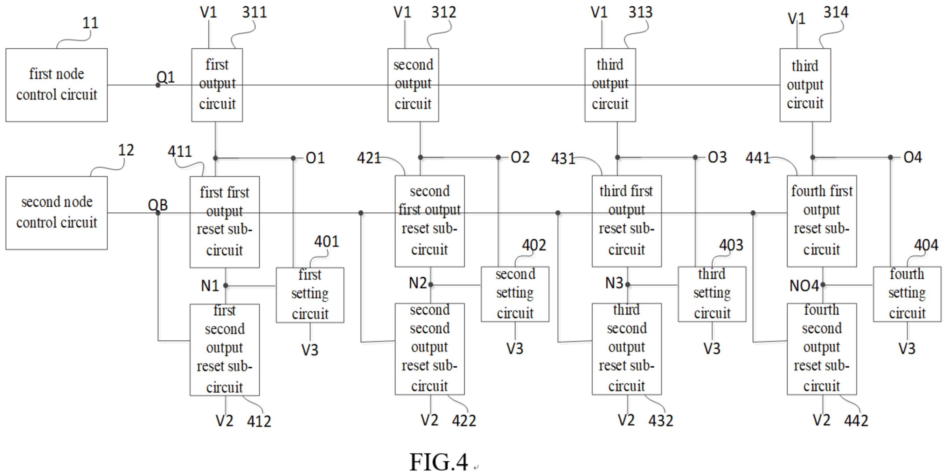

As shown in Fig.4, based on one embodiment of the driving circuit shown in FIG. 3, the first output reset circuit includes a first first output reset sub-circuit 411 and a first second output reset sub-circuit 412;

The first first output reset sub-circuit 411 is electrically connected to the second node QB, the first driving output terminal O1 and the first output node N1 respectively, and is configured to control the first driving output terminal O1 to be electrically connected to the first output node N1 under the control of the potential of the second node QB;

The first second output reset sub-circuit 412 is electrically connected to the second node QB, the first output node N1 and the second voltage terminal V2 respectively, and is configured to control the connection between the first output node N1 and the second voltage terminal V2 under the control of the potential of the second node QB;

The first driving output unit further includes a first setting circuit 401;

The first setting circuit 401 is electrically connected to the first driving output terminal O1, the first output node N1 and the third voltage terminal V3 respectively, and is configured to control the first output node N1 to be connected to the third voltage terminal V3 under the control of the first driving signal provided by the first driving output terminal O1;

The second output reset circuit includes a second first output reset sub-circuit 421 and a second second output reset sub-circuit 422;

The second first output reset sub-circuit 421 is electrically connected to the second node QB, the second driving output terminal O2 and the second output node N2 respectively, and is configured to control the second driving output terminal O2 to be electrically connected to the second output node N2 under the control of the potential of the second node QB;

The second second output reset sub-circuit 422 is electrically connected to the second node QB, the second output node N2 and the second voltage terminal V2 respectively, and is configured to control the connection between the second output node N2 and the second voltage terminal V2 under the control of the potential of the second node QB;

The second driving output unit further includes a second setting circuit 402;

The second setting circuit 402 is electrically connected to the second driving output terminal O2, the second output node N2 and the third voltage terminal V3 respectively, and is configured to control the second output node N2 to be connected to the third voltage terminal V3 under the control of the second driving signal provided by the second driving output terminal O2;

The third output reset circuit includes a third first output reset sub-circuit 431 and a third second output reset sub-circuit 432;

The third first output reset sub-circuit 431 is electrically connected to the second node QB, the third driving output terminal O3 and the third output node N3 respectively, and is configured to control the third driving output terminal O3 to be electrically connected to the third output node N3 under the control of the potential of the second node QB;

The third second output reset sub-circuit 432 is electrically connected to the second node QB, the third output node N3 and the second voltage terminal V2 respectively, and is configured to control the connection between the third output node N3 and the second voltage terminal V2 under the control of the potential of the second node QB;

The third driving output unit further includes a third setting circuit 403;

The third setting circuit 403 is electrically connected to the third driving output terminal O3, the third output node N3 and the third voltage terminal V3 respectively, and is configured to control the connection between the third output node N3 and the third voltage terminal V3 under the control of the third driving signal provided by the third driving output terminal O3;

The fourth output reset circuit includes a fourth first output reset sub-circuit 441 and a fourth second output reset sub-circuit 442;

The fourth first output reset sub-circuit 441 is electrically connected to the second node QB, the fourth driving output terminal O4 and the fourth output node NO4 respectively, and is configured to control the fourth driving output terminal O4 to be electrically connected to the fourth output node NO4 under the control of the potential of the second node QB;

The fourth second output reset sub-circuit 442 is electrically connected to the second node QB, the fourth output node NO4 and the second voltage terminal V2 respectively, and is configured to control the fourth output node NO4 to be connected to the second voltage terminal V2 under the control of the potential of the second node QB;

The fourth driving output unit further includes a fourth setting circuit 404;

The fourth setting circuit 404 is electrically connected to the fourth driving output terminal O4, the fourth output node NO4 and the third voltage terminal V3 respectively, and is configured to control the connection between the fourth output node NO4 and the third voltage terminal V3 under the control of the fourth driving signal provided by the fourth driving output terminal O4.

The driving circuit in at least one embodiment of the present disclosure further includes a first energy storage circuit;

The first terminal of the first energy storage circuit is electrically connected to the first node, the second terminal of the first energy storage circuit is electrically connected to one of the N driving output terminals, and the first energy storage circuit is configured to store electrical energy to maintain the potential of the first node.

In a specific implementation, the driving circuit may further include a first energy storage circuit, which is electrically connected to the first node and is used for storing capacitance.

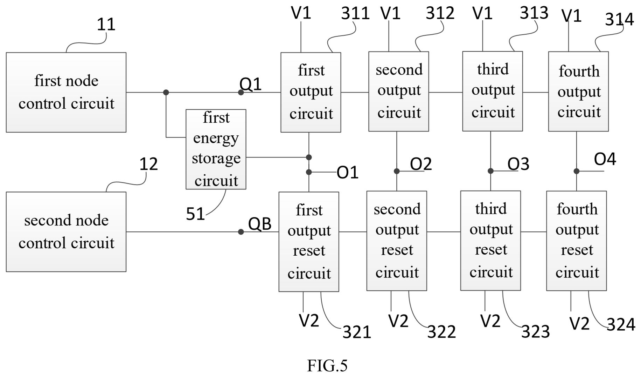

As shown in Fig.5, based on one embodiment of the driving circuit shown in FIG3, the driving circuit according to at least one embodiment of the present disclosure further includes a first energy storage circuit 51;

A first terminal of the first energy storage circuit 51 is electrically connected to the first node Q1, and a second terminal of the first energy storage circuit 51 is electrically connected to the first driving output terminal O1.

In one embodiment shown in FIG. 5, the capacitance value of the capacitor included in the first energy storage circuit 51 may be relatively large, which can save layout space, and the large capacitor has a stronger anti- noise capability.

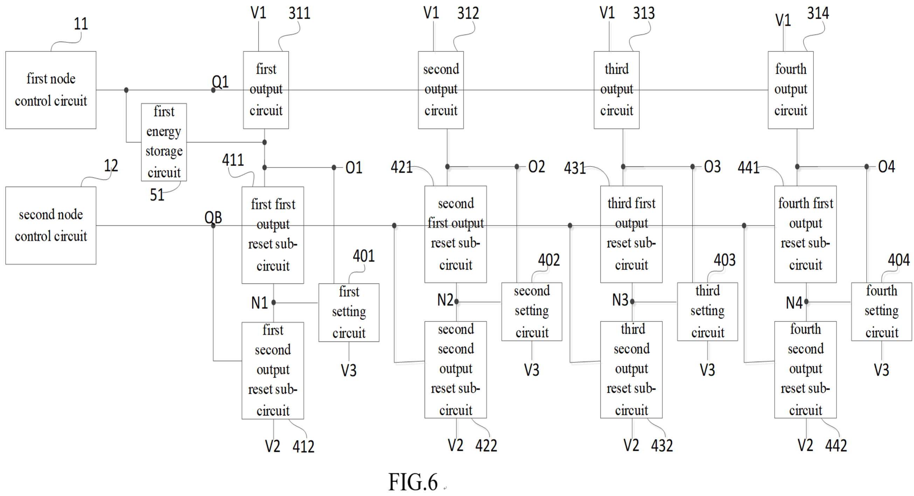

As shown in FIG.6, based on at least one embodiment of the driving circuit shown in FIG4, the driving circuit according to at least one embodiment of the present disclosure further includes a first energy storage circuit 51;

A first terminal of the first energy storage circuit 51 is electrically connected to the first node Q1, and a second terminal of the first energy storage circuit 51 is electrically connected to the first driving output terminal O1.

In one embodiment shown in FIG. 6, the capacitance value of the capacitor included in the first energy storage circuit 51 can be relatively large, which can save layout space, and the large capacitor has a stronger anti- noise capability.

The driving circuit in at least one embodiment of the present disclosure further includes at least two first energy storage circuits;

The first terminals of the at least two first energy storage circuits are electrically connected to the first node, the second terminals of the at least two first energy storage circuits are electrically connected to at least two of the driving output terminals respectively, and the first energy storage circuits are configured to store electrical energy.

In a specific implementation, the driving circuit may include N first energy storage circuits;
the n-th first energy storage circuit is electrically connected to the first node, and the second terminal of the n-th first energy storage circuit is electrically connected to the n-th driving output terminal.

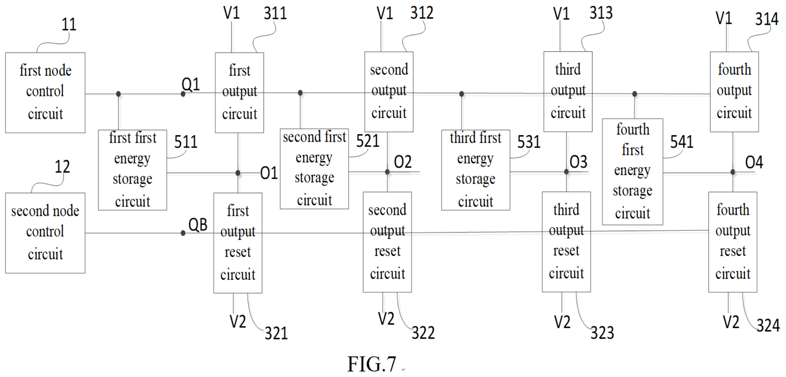

As shown in Fig.7, based on at least one embodiment of the driving circuit shown in FIG. 3, the driving circuit described in at least one embodiment of the present disclosure further includes a first first energy storage circuit 511, a second first energy storage circuit 521, a third first energy storage circuit 531, and a fourth first energy storage circuit 541;

A first terminal of the first first energy storage circuit 511 is electrically connected to the first node Q1, and a second terminal of the first first energy storage circuit 511 is electrically connected to the first driving output terminal O1;

A first terminal of the second first energy storage circuit 521 is electrically connected to the first node Q1, and a second terminal of the second first energy storage circuit 521 is electrically connected to the second driving output terminal O2;

The first terminal of the third first energy storage circuit 531 is electrically connected to the first node Q1, and the second terminal of the third first energy storage circuit 531 is electrically connected to the third driving output terminal O3;

The first terminal of the fourth first energy storage circuit 541 is electrically connected to the first node Q1, and the second terminal of the fourth first energy storage circuit 541 is electrically connected to the fourth driving output terminal O4.

In one embodiment shown in FIG. 7, four first energy storage circuits may be provided, and the capacitance values of the capacitors included in the four first energy storage circuits are all relatively small, so as to ensure that each driving output terminal has a capacitor to maintain the potential without being disturbed by other signals.

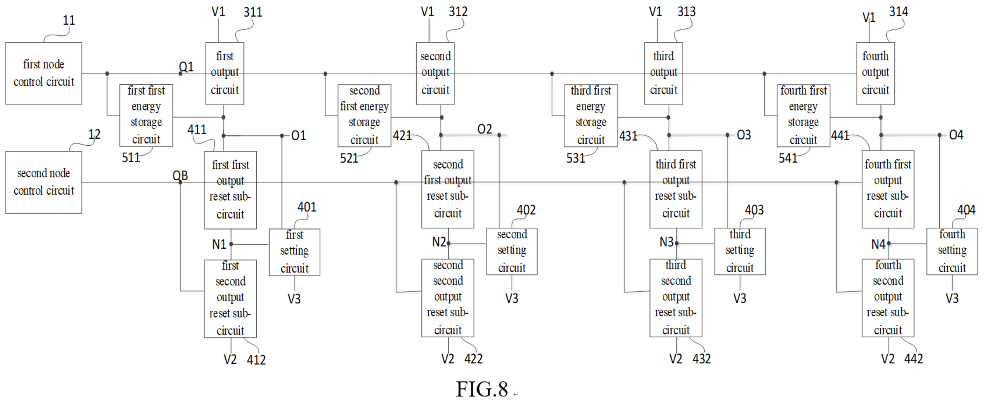

As shown in Fig.8, based on one embodiment of the driving circuit shown in FIG4, the driving circuit described in at least one embodiment of the present disclosure further includes a first first energy storage circuit 511, a second first energy storage circuit 521, a third first energy storage circuit 531, and a fourth first energy storage circuit 541;

A first terminal of the first first energy storage circuit 511 is electrically connected to the first node Q1, and a second terminal of the first first energy storage circuit 511 is electrically connected to the first driving output terminal O1;

A first terminal of the second first energy storage circuit 521 is electrically connected to the first node Q1, and a second terminal of the second first energy storage circuit 521 is electrically connected to the second driving output terminal O2;

The first terminal of the third first energy storage circuit 531 is electrically connected to the first node Q1, and the second terminal of the third first energy storage circuit 531 is electrically connected to the third driving output terminal O3;
the fourth first energy storage circuit 541 is electrically connected to the first node Q1, and the second terminal of the fourth first energy storage circuit 541 is electrically connected to the fourth driving output terminal O4.

In one embodiment shown in FIG. 8, four first energy storage circuits may be provided, and the capacitance values of the capacitors included in the four first energy storage circuits are all relatively small, so as to ensure that each driving output terminal has a capacitor to maintain the potential without being disturbed by other signals.

The driving circuit in at least one embodiment of the present disclosure further includes a second energy storage circuit;

The second energy storage circuit is electrically connected to the second node, and the second energy storage circuit is configured to store electrical energy.

In a specific implementation, the driving circuit may include a second energy storage circuit, which is electrically connected to the second node and is configured to maintain the potential of the second node.

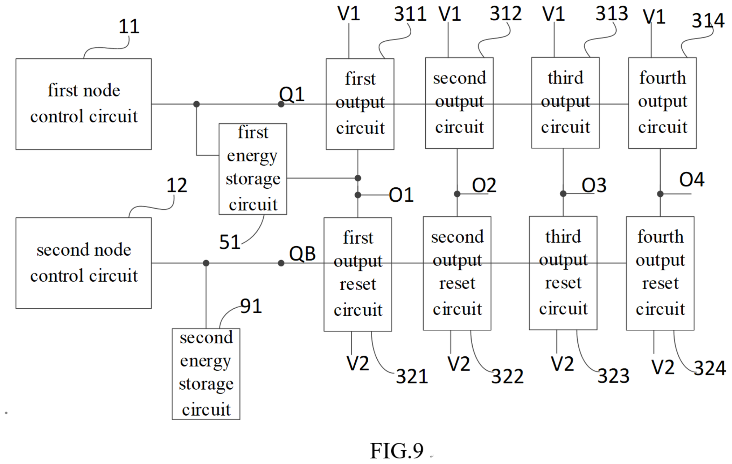

As shown in Fig.9, based on one embodiment of the driving circuit shown in FIG. 5, the driving circuit according to at least one embodiment of the present disclosure further includes a second energy storage circuit 91;

The second energy storage circuit 91 is electrically connected to the second node QB, and the second energy storage circuit 91 is used for storing electric energy.

In one embodiment shown in FIG. 9, the capacitance value of the capacitor included in the second energy storage circuit 91 may be relatively large, thereby saving layout space, and the large capacitor has a stronger anti- noise capability.

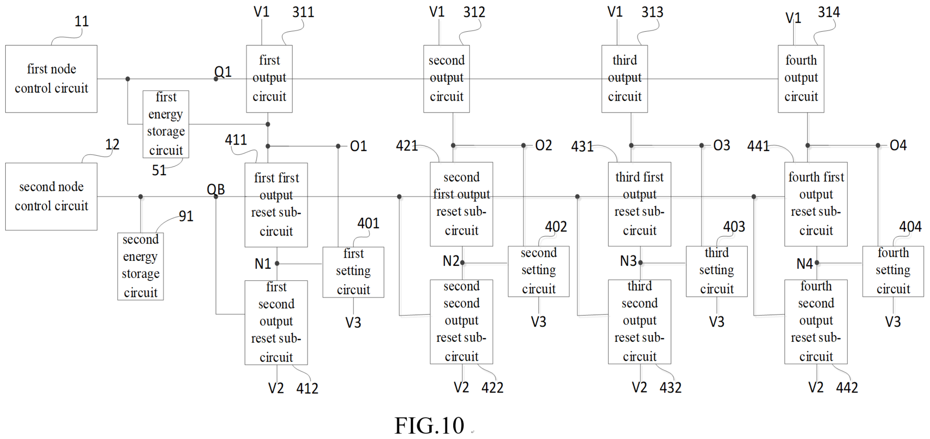

As shown in Fig.10, based on one embodiment of the driving circuit shown in FIG. 6, the driving circuit according to at least one embodiment of the present disclosure further includes a second energy storage circuit 91;

The second energy storage circuit 91 is electrically connected to the second node QB, and the second energy storage circuit 91 is used for storing electric energy.

In one embodiment shown in FIG. 10, the capacitance value of the capacitor included in the second energy storage circuit 91 may be relatively large, thereby saving layout space, and the large capacitor has a stronger anti- noise capability.

In at least one embodiment of the present disclosure, the control terminal of the n-th output reset circuit is electrically connected to the second node, the first terminal of the n-th output reset circuit is electrically connected to the n-th driving output terminal, and the second terminal of the n-th output reset circuit is electrically connected to the n-th second voltage terminal;

The driving circuit further includes at least two second energy storage circuits;

The first terminal of the second energy storage circuit is electrically connected to the second node, and the second terminal of the second energy storage circuit is electrically connected to the second terminal of one of the N output reset circuits; the second energy storage circuit is configured to store electrical energy.

In a specific implementation, the driving circuit may include N second energy storage circuits, the first terminal of the n-th second energy storage circuit is electrically connected to the second node, the second terminal of the n-th second energy storage circuit is electrically connected to the second terminal of the n-th output reset circuit, and the n-th second energy storage circuit can maintain the potential of the second node.

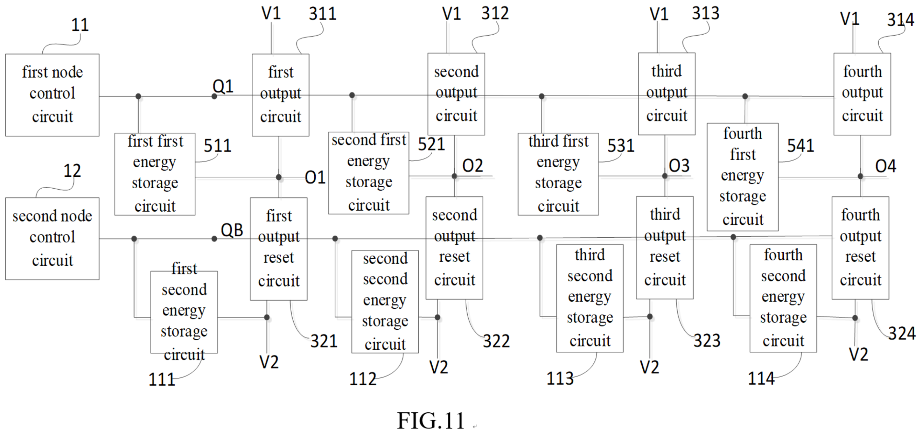

As shown in Fig.11, based on one embodiment of the driving circuit shown in FIG. 7,

The control terminal of the first output reset circuit 321 is electrically connected to the second node QB, the first terminal of the first output reset circuit 321 is electrically connected to the first driving output terminal O1, and the second terminal of the first output reset circuit 321 is electrically connected to the second voltage end V2;

The control terminal of the second output reset circuit 322 is electrically connected to the second node QB, the first terminal of the second output reset circuit 322 is electrically connected to the second driving output terminal O2, and the second terminal of the second output reset circuit 322 is electrically connected to the second voltage end V2;

The control terminal of the third output reset circuit 323 is electrically connected to the second node QB, the first terminal of the third output reset circuit 323 is electrically connected to the third driving output terminal O3, and the second terminal of the third output reset circuit 323 is electrically connected to the second voltage end V2;

The control terminal of the fourth output reset circuit 324 is electrically connected to the second node QB, the first terminal of the fourth output reset circuit 324 is electrically connected to the fourth driving output terminal O4, and the second terminal of the fourth output reset circuit 324 is electrically connected to the second voltage end V2;

The driving circuit further includes a first second energy storage circuit 111, a second second energy storage circuit 112, a third second energy storage circuit 113 and a fourth second energy storage circuit 114;

The first terminal of the first second energy storage circuit 111 is electrically connected to the second node QB, and the second terminal of the first second energy storage circuit 111 is electrically connected to the second voltage terminal V2; the first second energy storage circuit 111 is configured to store electrical energy;

The first terminal of the second second energy storage circuit 112 is electrically connected to the second node QB, and the second terminal of the second second energy storage circuit 112 is electrically connected to the second voltage terminal V2; the second second energy storage circuit 112 is configured to store electrical energy;

The first terminal of the third second energy storage circuit 113 is electrically connected to the second node QB, and the second terminal of the third second energy storage circuit 113 is electrically connected to the second voltage terminal V2; the third second energy storage circuit 113 is configured to store electrical energy;

The first terminal of the fourth second energy storage circuit 114 is electrically connected to the second node QB, and the second terminal of the fourth second energy storage circuit 114 is electrically connected to the second voltage terminal V2; the fourth second energy storage circuit 114 is configured to store electrical energy.

Optionally, the n-th output circuit includes an n-th output transistor, and the n-th output reset circuit includes an n-th output reset transistor;
a gate of the n-th output transistor is electrically connected to the first node, a first electrode of the n-th output transistor is electrically connected to the n-th first voltage terminal, and a second electrode of the n-th output transistor is electrically connected to the n-th driving output terminal;
a gate of the n-th output reset transistor is electrically connected to the second node, a first electrode of the n-th output reset transistor is electrically connected to the n-th driving output terminal, and the second electrode of the n-th output reset transistor is electrically connected to the n-th second voltage terminal.

Optionally, the n-th first output reset sub-circuit includes an n-th first output reset transistor, the n-th second output reset sub-circuit includes an n-th second output reset transistor, and the n-th setting circuit includes an n-th setting transistor;
the n-th first output reset transistor is electrically connected to the second node, the first electrode of the n-th first output reset transistor is electrically connected to the n-th driving output terminal, and the second electrode of the n-th first output reset transistor is electrically connected to the n-th output node;
the n-th second output reset transistor is electrically connected to the second node, the first electrode of the n-th second output reset transistor is electrically connected to the n-th output node, and the second electrode of the n-th second output reset transistor is electrically connected to the n-th second voltage terminal;

The gate of the n-th setting transistor is electrically connected to the n-th driving output terminal, the first electrode of the n-th setting transistor is electrically connected to the n-th output node, and the second electrode of the n-th setting transistor is electrically connected to the third voltage terminal.

Optionally, the driving output circuit includes an output transistor and an output reset transistor;
the gate of the output transistor is electrically connected to the first node, the first electrode of the output transistor is electrically connected to the first voltage terminal, and the second electrode of the output transistor is electrically connected to the N driving output terminals respectively;
the gate of the output reset transistor is electrically connected to the N driving output terminals, and the second electrode of the output reset transistor is electrically connected to the second voltage terminal.

In at least one embodiment of the present disclosure, the first node control circuit is also electrically connected to the first clock signal terminal, the input terminal, the third node, the fourth voltage terminal, the fifth voltage terminal and the reset terminal, respectively, and is configured to control the connection between the first node and the fourth voltage terminal under the control of the first clock signal provided by the first clock signal terminal and the input signal provided by the input terminal, control the connection between the first node and the first clock signal terminal under the control of the reset signal provided by the reset terminal, and control the connection between the first node and the fifth voltage terminal under the control of the potential of the third node and the first clock signal.

In a specific implementation, the first node control circuit can control the connection between the first node and the fourth voltage terminal under the control of the first clock signal and the input signal, control the connection between the first node and the first clock signal terminal under the control of the reset signal, and control the connection between the first node and the fifth voltage terminal under the control of the potential of the third node and the first clock signal.

Optionally, the fourth voltage terminal may be a high voltage terminal, and the fifth voltage terminal may be the first low voltage terminal, but is not limited thereto.

In at least one embodiment of the present disclosure, the first node control circuit is also electrically connected to the intermediate node, the first clock signal terminal, the input terminal, the third node, the fourth voltage terminal, the fifth voltage terminal and the reset terminal, respectively, and is configured to control the connection between the intermediate node and the fourth voltage terminal under the control of the first clock signal provided by the first clock signal terminal and the input signal provided by the input terminal, control the connection between the intermediate node and the first clock signal terminal under the control of the reset signal provided by the reset terminal, control the connection between the intermediate node and the fifth voltage terminal under the control of the potential of the third node and the first clock signal, and control the connection between the intermediate node and the first node under the control of the fourth voltage signal provided by the fourth voltage terminal.

In a specific implementation, the first node control circuit can control the connection between the intermediate node and the fourth voltage terminal under the control of the first clock signal and the input signal, control the connection between the intermediate node and the first clock signal terminal under the control of the reset signal, control the connection between the intermediate node and the fifth voltage terminal under the control of the potential of the third node and the first clock signal, and control the connection between the intermediate node and the first node under the control of the fourth voltage signal provided by the fourth voltage terminal.

In at least one embodiment of the present disclosure, the driving circuit further includes a third node control circuit and a carry output circuit;

The third node control circuit is electrically connected to the third node and is configured to control the potential of the third node;

The second node control circuit is also electrically connected to the third node, the first clock signal terminal, the first node, the fourth node and the fifth voltage terminal, respectively, and is configured to control the second node to be connected to the fourth node under the control of the first clock signal, control the fourth node to be connected to the second node under the control of the first clock signal, and control the second node to be connected to the fifth voltage terminal under the control of the potential of the first node;

The carry output circuit is electrically connected to the first node, the second node, the carry output terminal, the first voltage terminal and the fifth voltage terminal, respectively, and is configured to control the connection between the carry output terminal and the first voltage terminal under the control of the potential of the first node, and to control the connection between the carry output terminal and the fifth voltage terminal under the control of the potential of the second node.

In a specific implementation, the drive circuit may also include a third node control circuit and a carry output circuit; the third node control circuit controls the potential of the third node; the second node control circuit controls the connection between the second node and the fourth node under the control of the first clock signal, controls the connection between the fourth node and the second node under the control of the first clock signal, and controls the connection between the second node and the fifth voltage terminal under the control of the potential of the first node; the carry output circuit controls the connection between the carry output terminal and the first voltage terminal under the control of the potential of the first node, and controls the connection between the carry output terminal and the fifth voltage terminal under the control of the potential of the second node.

Optionally, the second node control circuit is also electrically connected to the reset terminal and the fourth voltage terminal, respectively, and is configured to control the connection between the second node and the fourth voltage terminal under the control of a reset signal provided by the reset terminal.

In a specific implementation, the second node control circuit can also control the connection between the third node and the fourth voltage terminal under the control of a reset signal.

In at least one embodiment of the present disclosure, the third node control circuit is also electrically connected to the second clock signal terminal, the fourth voltage terminal, the input terminal, the fourth node and the fifth node, respectively, and is configured to control the connection between the third node and the fourth voltage terminal under the control of the second clock signal provided by the second clock signal terminal, control the connection between the third node and the fifth node under the control of the input signal provided by the input terminal, control the connection between the fifth node and the second clock signal terminal, control the connection between the fifth node and the fourth voltage terminal under the control of the potential of the third node, and control the potential of the third node according to the potential of the fourth node.

In a specific implementation, the third node control circuit can control the connection between the third node and the fourth voltage terminal under the control of the second clock signal, control the connection between the third node and the fifth node under the control of the input signal, control the connection between the fifth node and the second clock signal terminal, control the connection between the fifth node and the fourth voltage terminal under the control of the potential of the third node, and control the potential of the third node according to the potential of the fourth node.

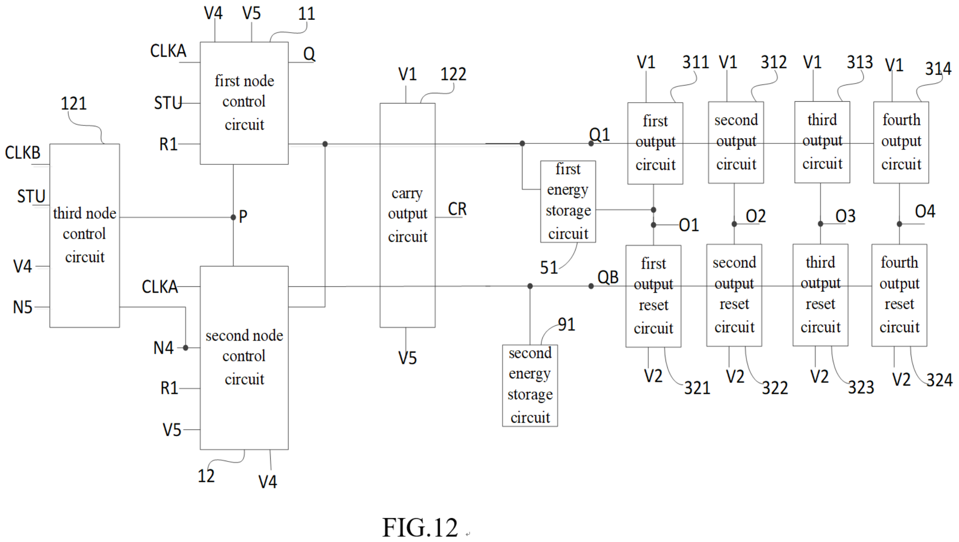

As shown in Fig.12, based on one embodiment of the driving circuit shown in FIG. 9,

The first node control circuit 11 is also electrically connected to the intermediate node Q, the first clock signal terminal CLKA, the input terminal STU, the third node P, the fourth voltage terminal V4, the fifth voltage terminal V5 and the reset terminal R1, respectively, and is configured to control the connection between the intermediate node Q and the fourth voltage terminal V4 under the control of the first clock signal provided by the first clock signal terminal CLKA and the input signal provided by the input terminal STU, control the connection between the intermediate node Q and the first clock signal terminal CLKA under the control of the reset signal provided by the reset terminal R1, control the connection between the intermediate node Q and the fifth voltage terminal V5 under the control of the potential of the third node P and the first clock signal, and control the connection between the intermediate node Q and the first node Q1 under the control of the fourth voltage signal provided by the fourth voltage terminal V4;

The driving circuit further includes a third node control circuit 121 and a carry output circuit 122;

The third node control circuit 121 is electrically connected to the third node P, and is configured to control the potential of the third node P;

The second node control circuit 12 is also electrically connected to the third node P, the first clock signal terminal CLKA, the first node Q1, the fourth node N4 and the fifth voltage terminal V5, respectively, and is configured to control the second node QB to be connected to the fourth node N4 under the control of the first clock signal, control the fourth node N4 to be connected to the second node QB under the control of the first clock signal, and control the second node QB to be connected to the fifth voltage terminal V5 under the control of the potential of the first node Q1;

The carry output circuit 122 is electrically connected to the first node Q1, the second node QB, the carry output terminal CR, the first voltage terminal V1 and the fifth voltage terminal V5, respectively, and is configured to control the carry output terminal CR to be connected to the first voltage terminal V1 under the control of the potential of the first node Q1, and to control the carry output terminal CR to be connected to the fifth voltage terminal V5 under the control of the potential of the second node QB;

The second node control circuit 12 is also electrically connected to the reset terminal R1 and the fourth voltage terminal V4 respectively, and is configured to control the second node QB to be connected to the fourth voltage terminal V4 under the control of the reset signal provided by the reset terminal R1;

The third node control circuit 121 is also electrically connected to the second clock signal terminal CLKB, the fourth voltage terminal V4, the input terminal STU, the fourth node N4 and the fifth node N5, respectively, and is configured to control the connection between the third node P and the fourth voltage terminal V4 under the control of the second clock signal provided by the second clock signal terminal CLKB, control the connection between the third node P and the fifth node N5 under the control of the input signal provided by the input terminal STU, control the connection between the fifth node N5 and the second clock signal terminal CLKB, control the connection between the fifth node N5 and the fourth voltage terminal V4 under the control of the potential of the third node P, and control the potential of the third node P according to the potential of the fourth node N4.

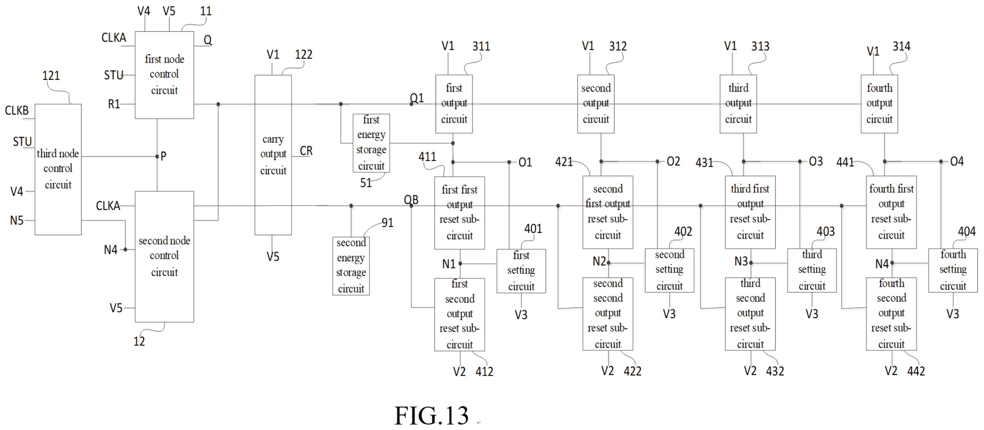

As shown in Fig.13, based on one embodiment of the driving circuit shown in FIG10, the first node control circuit 11 is further electrically connected to the intermediate node Q, the first clock signal terminal CLKA, the input terminal STU, the third node P, the fourth voltage terminal V4, the fifth voltage terminal V5 and the reset terminal R1, respectively, and is configured to control the connection between the intermediate node Q and the fourth voltage terminal V4 under the control of the first clock signal provided by the first clock signal terminal CLKA and the input signal provided by the input terminal STU, control the connection between the intermediate node Q and the first clock signal terminal CLKA under the control of the reset signal provided by the reset terminal R1, control the connection between the intermediate node Q and the first clock signal terminal CLKA under the control of the potential of the third node P and the first clock signal, and control the connection between the intermediate node Q and the first node Q1 under the control of the fourth voltage signal provided by the fourth voltage terminal V4;

The driving circuit further includes a third node control circuit 121 and a carry output circuit 122;

The third node control circuit 121 is electrically connected to the third node P, and is configured to control the potential of the third node P;

The second node control circuit 12 is also electrically connected to the third node P, the first clock signal terminal CLKA, the first node Q1, the fourth node N4 and the fifth voltage terminal V5, respectively, and is configured to control the second node QB to be connected to the fourth node N4 under the control of the first clock signal, control the fourth node N4 to be connected to the second node QB under the control of the first clock signal, and control the second node QB to be connected to the fifth voltage terminal V5 under the control of the potential of the first node Q1;

The carry output circuit 122 is electrically connected to the first node Q1, the second node QB, the carry output terminal CR, the first voltage terminal V1 and the fifth voltage terminal V5, respectively, and is configured to control the carry output terminal CR to be connected to the first voltage terminal V1 under the control of the potential of the first node Q1, and to control the carry output terminal CR to be connected to the fifth voltage terminal V5 under the control of the potential of the second node QB;

The third node control circuit 121 is also electrically connected to the second clock signal terminal CLKB, the fourth voltage terminal V4, the input terminal STU, the fourth node N4 and the fifth node N5, respectively, and is configured to control the connection between the third node P and the fourth voltage terminal V4 under the control of the second clock signal provided by the second clock signal terminal CLKB, control the connection between the third node P and the fifth node N5 under the control of the input signal provided by the input terminal STU, control the connection between the fifth node N5 and the second clock signal terminal CLKB, control the connection between the fifth node N5 and the fourth voltage terminal V4 under the control of the potential of the third node P, and control the potential of the third node P according to the potential of the fourth node N4.

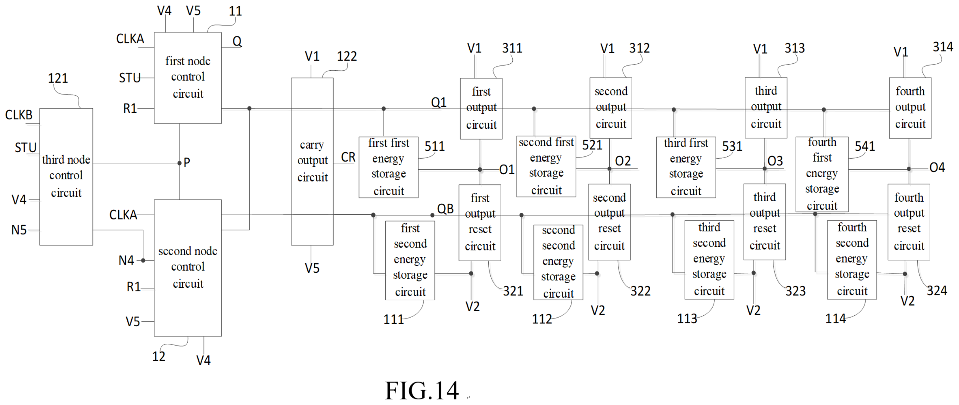

As shown in Fig.14, based on one embodiment of the driving circuit shown in FIG. 11,

The first node control circuit 11 is also electrically connected to the intermediate node Q, the first clock signal terminal CLKA, the input terminal STU, the third node P, the fourth voltage terminal V4, the fifth voltage terminal V5 and the reset terminal R1, respectively, and is configured to control the connection between the intermediate node Q and the fourth voltage terminal V4 under the control of the first clock signal provided by the first clock signal terminal CLKA and the input signal provided by the input terminal STU, control the connection between the intermediate node Q and the first clock signal terminal CLKA under the control of the reset signal provided by the reset terminal R1, control the connection between the intermediate node Q and the fifth voltage terminal V5 under the control of the potential of the third node P and the first clock signal, and control the connection between the intermediate node Q and the first node Q1 under the control of the fourth voltage signal provided by the fourth voltage terminal V4;

The driving circuit further includes a third node control circuit 121 and a carry output circuit 122;

The third node control circuit 121 is electrically connected to the third node P, and is configured to control the potential of the third node P;

The second node control circuit 12 is also electrically connected to the third node P, the first clock signal terminal CLKA, the first node Q1, the fourth node N4 and the fifth voltage terminal V5, respectively, and is configured to control the second node QB to be connected to the fourth node N4 under the control of the first clock signal, control the fourth node N4 to be connected to the second node QB under the control of the first clock signal, and control the second node QB to be connected to the fifth voltage terminal V5 under the control of the potential of the first node Q1;

The carry output circuit 122 is electrically connected to the first node Q1, the second node QB, the carry output terminal CR, the first voltage terminal V1 and the fifth voltage terminal V5, respectively, and is configured to control the carry output terminal CR to be connected to the first voltage terminal V1 under the control of the potential of the first node Q1, and to control the carry output terminal CR to be connected to the fifth voltage terminal V5 under the control of the potential of the second node QB;

The second node control circuit 12 is also electrically connected to the reset terminal R1 and the fourth voltage terminal V4 respectively, and is configured to control the second node QB to be connected to the fourth voltage terminal V4 under the control of the reset signal provided by the reset terminal R1;

The third node control circuit 121 is also electrically connected to the second clock signal terminal CLKB, the fourth voltage terminal V4, the input terminal STU, the fourth node N4 and the fifth node N5, respectively, and is configured to control the connection between the third node P and the fourth voltage terminal V4 under the control of the second clock signal provided by the second clock signal terminal CLKB, control the connection between the third node P and the fifth node N5 under the control of the input signal provided by the input terminal STU, control the connection between the fifth node N5 and the second clock signal terminal CLKB, control the connection between the fifth node N5 and the fourth voltage terminal V4 under the control of the potential of the third node P, and control the potential of the third node P according to the potential of the fourth node N4.

one embodiment of the driving circuit shown in FIG. 1, the driving circuit according to at least one embodiment of the present disclosure further includes a first energy storage circuit 51;

The first terminal of the first energy storage circuit 51 is electrically connected to the first node Q1, and the second terminal of the first energy storage circuit 51 is electrically connected to the first driving output terminal O1;

The driving circuit in at least one embodiment of the present disclosure further includes a second energy storage circuit 91;

The second energy storage circuit 91 is electrically connected to the second node QB, and the second energy storage circuit 91 is configured to store electrical energy;

The first node control circuit 11 is also electrically connected to the intermediate node Q, the first clock signal terminal CLKA, the input terminal STU, the third node P, the fourth voltage terminal V4, the fifth voltage terminal V5 and the reset terminal R1, respectively, and is configured to control the connection between the intermediate node Q and the fourth voltage terminal V4 under the control of the first clock signal provided by the first clock signal terminal CLKA and the input signal provided by the input terminal STU, control the connection between the intermediate node Q and the first clock signal terminal CLKA under the control of the reset signal provided by the reset terminal R1, control the connection between the intermediate node Q and the fifth voltage terminal V5 under the control of the potential of the third node P and the first clock signal, and control the connection between the intermediate node Q and the first node Q1 under the control of the fourth voltage signal provided by the fourth voltage terminal V4;

The driving circuit further includes a third node control circuit 121 and a carry output circuit 122;

The third node control circuit 121 is electrically connected to the third node P, and is configured to control the potential of the third node P;

The second node control circuit 12 is also electrically connected to the third node P, the first clock signal terminal CLKA, the first node Q1, the fourth node N4 and the fifth voltage terminal V5, respectively, and is configured to control the second node QB to be connected to the fourth node N4 under the control of the first clock signal, control the fourth node N4 to be connected to the second node QB under the control of the first clock signal, and control the second node QB to be connected to the fifth voltage terminal V5 under the control of the potential of the first node Q1;

The carry output circuit 122 is electrically connected to the first node Q1, the second node QB, the carry output terminal CR, the first voltage terminal V1 and the fifth voltage terminal V5, respectively, and is configured to control the carry output terminal CR to be connected to the first voltage terminal V1 under the control of the potential of the first node Q1, and to control the carry output terminal CR to be connected to the fifth voltage terminal V5 under the control of the potential of the second node QB;

The second node control circuit 12 is also electrically connected to the reset terminal R1 and the fourth voltage terminal V4 respectively, and is configured to control the second node QB to be connected to the fourth voltage terminal V4 under the control of the reset signal provided by the reset terminal R1;

The third node control circuit 121 is also electrically connected to the second clock signal terminal CLKB, the fourth voltage terminal V4, the input terminal STU, the fourth node N4 and the fifth node N5, respectively, and is configured to control the connection between the third node P and the fourth voltage terminal V4 under the control of the second clock signal provided by the second clock signal terminal CLKB, control the connection between the third node P and the fifth node N5 under the control of the input signal provided by the input terminal STU, control the connection between the fifth node N5 and the second clock signal terminal CLKB, control the connection between the fifth node N5 and the fourth voltage terminal V4 under the control of the potential of the third node P, and control the potential of the third node P according to the potential of the fourth node N4.

Optionally, the first node control circuit includes a first transistor, a second transistor, a third transistor, a fourth transistor and a fifth transistor;
a gate of the first transistor is the first clock signal terminal, the first electrode of the first transistor is electrically connected to the fourth voltage terminal, and the second electrode of the first transistor is electrically connected to the first electrode of the second transistor;
a gate of the second transistor is electrically connected to the input terminal, and the second electrode of the second transistor is electrically connected to the first node;
a gate of the third transistor is electrically connected to the third node, the first electrode of the third transistor is electrically connected to the first node, and the second electrode of the third transistor is electrically connected to the first electrode of the fourth transistor;
a gate of the fourth transistor is electrically connected to the first clock signal terminal, and the second electrode of the fourth transistor is electrically connected to the fifth voltage terminal;
a gate of the fifth transistor is electrically connected to the reset terminal, a first electrode of the fifth transistor is electrically connected to the first clock signal terminal, and a second electrode of the fifth transistor is electrically connected to the first node.

Optionally, the first node control circuit includes a first transistor, a second transistor, a third transistor, a fourth transistor, a fifth transistor and a sixth transistor;
a gate of the first transistor is electrically connected to the first clock signal terminal, the first electrode of the first transistor is electrically connected to the fourth voltage terminal, and the second electrode of the first transistor is electrically connected to the first electrode of the second transistor;
a gate of the second transistor is electrically connected to the input terminal, and the second electrode of the second transistor is electrically connected to the intermediate node;
a gate of the third transistor is electrically connected to the third node, the first electrode of the third transistor is electrically connected to the intermediate node, and the second electrode of the third transistor is electrically connected to the first electrode of the fourth transistor;
a gate of the fourth transistor is electrically connected to the first clock signal terminal, and the second electrode of the fourth transistor is electrically connected to the fifth voltage terminal;
a gate of the fifth transistor is electrically connected to the reset terminal, the first electrode of the fifth transistor is electrically connected to the first clock signal terminal, and the second electrode of the fifth transistor is electrically connected to the intermediate node.
a gate of the sixth transistor is electrically connected to the fourth voltage terminal, a first electrode of the sixth transistor is electrically connected to the intermediate node, and a second electrode of the sixth transistor is electrically connected to the first node.

Optionally, the second node control circuit includes a seventh transistor, an eighth transistor and a ninth transistor;
a gate of the seventh transistor is electrically connected to the third node, the first electrode of the seventh transistor is electrically connected to the first clock signal terminal, and the second electrode of the seventh transistor is electrically connected to the fourth node;
a gate of the eighth transistor is electrically connected to the first clock signal terminal, the first electrode of the eighth transistor is electrically connected to the fourth node, and the second electrode of the eighth transistor is electrically connected to the second node;
a gate of the ninth transistor is electrically connected to the first node, a first electrode of the ninth transistor is electrically connected to the second node, and a second electrode of the ninth transistor is electrically connected to the fifth voltage terminal.

Optionally, the second node control circuit further includes a tenth transistor;
a gate of the tenth transistor is electrically connected to the reset terminal, a first electrode of the tenth transistor is electrically connected to the second node, and a second electrode of the tenth transistor is electrically connected to the fourth voltage terminal.

Optionally, the third node control circuit includes an eleventh transistor, a twelfth transistor, a thirteenth transistor, a fourteenth transistor and a third capacitor;
the gate of the eleventh transistor is electrically connected to the second clock signal terminal, the first electrode of the eleventh transistor is electrically connected to the fourth voltage terminal, and the second electrode of the eleventh transistor is electrically connected to the third node;
the gate of the twelfth transistor is electrically connected to the input terminal, the first electrode of the twelfth transistor is electrically connected to the third node, and the second electrode of the twelfth transistor is electrically connected to the fifth node;
the gate of the thirteenth transistor is electrically connected to the input terminal, the first electrode of the thirteenth transistor is electrically connected to the fifth node, and the second electrode of the thirteenth transistor is electrically connected to the second clock signal terminal;
the gate of the fourteenth transistor is electrically connected to the third node, the first electrode of the fourteenth transistor is electrically connected to the fourth voltage terminal, and the second electrode of the fourteenth transistor is electrically connected to the fifth node;
the first electrode plate of the third capacitor is electrically connected to the third node, and the second electrode plate of the third capacitor is electrically connected to the fourth node.

Optionally, the carry output circuit includes a fifteenth transistor and a sixteenth transistor;
the gate of the fifteenth transistor is electrically connected to the first node, the first electrode of the fifteenth transistor is electrically connected to the first voltage terminal, and the second electrode of the fifteenth transistor is electrically connected to the carry output terminal;
a gate of the sixteenth transistor is electrically connected to the second node, a first electrode of the sixteenth transistor is electrically connected to the carry output terminal, and a second electrode of the sixteenth transistor is electrically connected to the fifth voltage terminal.

Optionally, the first energy storage circuit includes a first capacitor;
the first electrode plate of the first capacitor is electrically connected to the first node, and the second electrode plate of the first capacitor is electrically connected to one of the N driving output terminals.

In at least one embodiment of the present disclosure, the driving circuit includes N first energy storage circuits, and the n-th first energy storage circuit includes an n-th first capacitor;
the n-th first capacitor is electrically connected to the first node, and the second electrode plate of the n-th first capacitor is electrically connected to the n-th driving output terminal.

Optionally, the second energy storage circuit includes a second capacitor;

The first electrode plate of the second capacitor is electrically connected to the second node, and the second electrode plate of the second capacitor is electrically connected to the second terminal of one of the N output reset circuits.

In at least one embodiment of the present disclosure, the driving circuit includes N second energy storage circuits; the n-th second energy storage circuit includes an n-th second capacitor;
the n-th second capacitor is electrically connected to the second node, and the second electrode plate of the n-th second capacitor is electrically connected to the second terminal of the n-th output reset circuit.

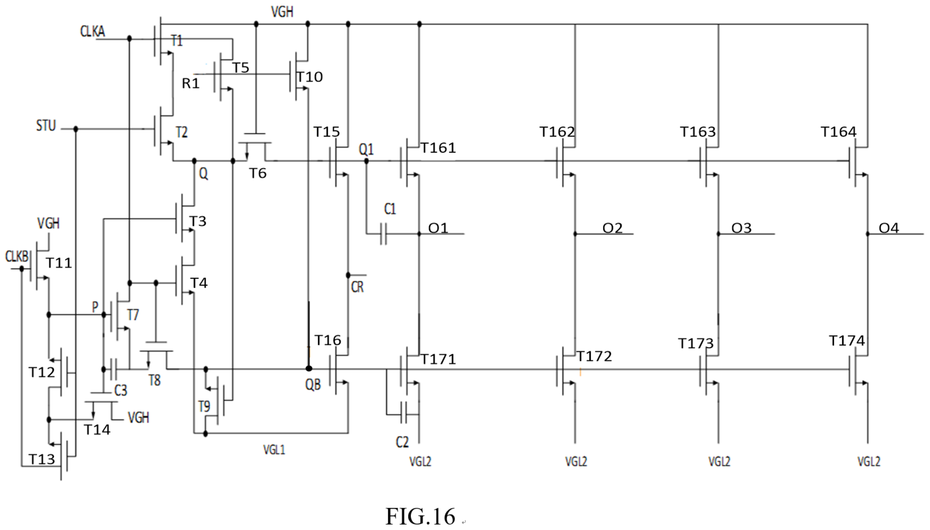

As shown in FIG. 16, based on at least one embodiment of the driving circuit shown in FIG. 12, the first node control circuit includes a first transistor T1, a second transistor T2, a third transistor T3, a fourth transistor T4, a fifth transistor T5 and a sixth transistor T6;

The gate of the first transistor T1 is electrically connected to the first clock signal terminal CLKA, the drain of the first transistor T1 is electrically connected to the high voltage terminal VGH, and the source of the first transistor T1 is electrically connected to the drain of the second transistor T2;

The gate of the second transistor T2 is electrically connected to the input terminal STU, and the source of the second transistor T2 is electrically connected to the intermediate node Q;

The gate of the third transistor T3 is electrically connected to the third node P, the drain of the third transistor T3 is electrically connected to the intermediate node Q, and the source of the third transistor T3 is electrically connected to the drain of the fourth transistor T4;

The gate of the fourth transistor T4 is electrically connected to the first clock signal terminal CLKA, and the source of the fourth transistor T4 is electrically connected to the first low voltage terminal VGL1; the fifth voltage terminal may be the first low voltage terminal VGL1;

The gate of the fifth transistor T5 is electrically connected to the reset terminal R1, the drain of the fifth transistor T5 is electrically connected to the first clock signal terminal CLKA, and the source of the fifth transistor T5 is electrically connected to the intermediate node Q;

The gate of the sixth transistor T6 is electrically connected to the high voltage terminal VGH, the drain of the sixth transistor T6 is electrically connected to the intermediate node Q, and the source of the sixth transistor T6 is electrically connected to the first node Q1; the fourth voltage terminal may be the high voltage terminal VGH;

The second node control circuit includes a seventh transistor T7, an eighth transistor T8 and a ninth transistor T9;

The gate of the seventh transistor T7 is electrically connected to the third node P, the drain of the seventh transistor T7 is electrically connected to the first clock signal terminal CLKA, and the source of the seventh transistor T7 is electrically connected to the fourth node N4;

The gate of the eighth transistor T8 is electrically connected to the first clock signal terminal CLKA, the drain of the eighth transistor T8 is electrically connected to the fourth node N4, and the source of the eighth transistor T8 is electrically connected to the second node QB;

the ninth transistor T9 is electrically connected to the first node Q1, the drain of the ninth transistor T9 is electrically connected to the second node QB, and the source of the ninth transistor T9 is electrically connected to the first low voltage terminal VGL1;

The second node control circuit further includes a tenth transistor T10;

The gate of the tenth transistor T10 is electrically connected to the reset terminal R1, the drain of the tenth transistor T10 is electrically connected to the second node QB, and the source of the tenth transistor T10 is electrically connected to the high voltage terminal VGH;

The third node control circuit includes an eleventh transistor T11, a twelfth transistor T12, a thirteenth transistor T13, a fourteenth transistor T14 and a third capacitor C3;

The gate of the eleventh transistor T11 is electrically connected to the second clock signal terminal CLKB, the drain of the eleventh transistor T11 is electrically connected to the high voltage terminal VGH, and the source of the eleventh transistor T11 is electrically connected to the third node P;

The gate of the twelfth transistor T12 is electrically connected to the input terminal STU, the drain of the twelfth transistor T12 is electrically connected to the third node P, and the source of the twelfth transistor T12 is electrically connected to the fifth node N5;

The gate of the thirteenth transistor T13 is electrically connected to the input terminal STU, the drain of the thirteenth transistor T13 is electrically connected to the fifth node N5, and the source of the thirteenth transistor T13 is electrically connected to the second clock signal terminal CLKB;

The gate of the fourteenth transistor T14 is electrically connected to the third node P, the drain of the fourteenth transistor T14 is electrically connected to the high voltage terminal VGH, and the source of the fourteenth transistor T14 is electrically connected to the fifth node N5;

The first electrode plate of the third capacitor C3 is electrically connected to the third node P, and the second electrode plate of the third capacitor C3 is electrically connected to the fourth node N4;

The carry output circuit includes a fifteenth transistor T15 and a sixteenth transistor T16;

The gate of the fifteenth transistor T15 is electrically connected to the first node Q1, the drain of the fifteenth transistor T15 is electrically connected to the high voltage terminal VGH, and the source of the fifteenth transistor T15 is electrically connected to the carry output terminal CR;

The gate of the sixteenth transistor T16 is electrically connected to the second node QB, the drain of the sixteenth transistor T16 is electrically connected to the carry output terminal CR, and the source of the sixteenth transistor T16 is electrically connected to the first low voltage terminal VGL1;

The first energy storage circuit includes a first capacitor C1, and the second energy storage circuit includes a second capacitor C2;

The first electrode plate of the first capacitor C1 is electrically connected to the first node Q1, and the second electrode plate of the first capacitor C1 is electrically connected to the first driving output terminal O1;

A first electrode plate of the second capacitor C2 is electrically connected to the second node QB, and a second electrode plate of the second capacitor C2 is electrically connected to the second low voltage terminal VGL2;

The first output circuit includes a first output transistor T161, and the first output reset circuit includes a first output reset transistor T171;

The second output circuit includes a second output transistor T162, and the second output reset circuit includes a second output reset transistor T172;

The third output circuit includes a third output transistor T163, and the third output reset circuit includes a third output reset transistor T173;

The fourth output circuit includes a fourth output transistor T164, and the fourth output reset circuit includes a fourth output reset transistor T174;

The gate of T161 is electrically connected to the first node Q1, the drain of T161 is electrically connected to the high voltage terminal VGH, and the source of T161 is electrically connected to the first driving output terminal O1; the first voltage terminal is the high voltage terminal VGH;

The gate of T171 is electrically connected to the second node QB, the drain of T171 is electrically connected to the first driving output terminal O1, and the source of T171 is electrically connected to the second low voltage terminal VGL2; the second voltage terminal is the second low voltage terminal VGL2;

The gate of T162 is electrically connected to the first node Q1, the drain of T162 is electrically connected to the high voltage terminal VGH, and the source of T162 is electrically connected to the second driving output terminal O2;

The gate of T172 is electrically connected to the second node QB, the drain of T172 is electrically connected to the second driving output terminal O2, and the source of T172 is electrically connected to the second low voltage terminal VGL2;

The gate of T163 is electrically connected to the first node Q1, the drain of T163 is electrically connected to the high voltage terminal VGH, and the source of T163 is electrically connected to the third driving output terminal O3;

The gate of T173 is electrically connected to the second node QB, the drain of T173 is electrically connected to the third driving output terminal O3, and the source of T173 is electrically connected to the second low voltage terminal VGL2;

The gate of T164 is electrically connected to the first node Q1, the drain of T164 is electrically connected to the high voltage terminal VGH, and the source of T164 is electrically connected to the fourth driving output terminal O4;

The gate of T174 is electrically connected to the second node QB, the drain of T174 is electrically connected to the fourth driving output terminal O4, and the source of T174 is electrically connected to the second low voltage terminal VGL2.

In at least one embodiment of the driving circuit shown in FIG. 16, all transistors are n-type transistors, but the present invention is not limited thereto.

In at least one embodiment of the driving circuit shown in FIG. 16, each driving output terminal can be configured to provide a second driving control signal or a third driving control signal, but the present invention is not limited thereto.

In at least one embodiment of the present disclosure, the voltage value of the first low voltage signal provided by the first low voltage terminal VGL1 may be greater than or equal to - 8V and less than or equal to -5V, and the voltage value of the second low voltage signal provided by the second low voltage terminal VGL2 may be greater than or equal to -8V and less than or equal to -5V;

The voltage value of the first low voltage signal may be equal to the voltage value of the second low voltage signal, or the voltage value of the first low voltage signal may be smaller than the voltage value of the second low voltage signal.

In at least one embodiment of the driving circuit shown in FIG.16, the capacitance value of C1 may be greater than or equal to 2 pF and less than or equal to 4 pF, and the capacitance value of C2 may be greater than or equal to 300 fF and less than or equal to 500 fF;
the channel width-to-length ratio range of T161 may be greater than or equal to 22×8µm/5µm and less than or equal to 22×12µm/5µm, and the channel width-to- length ratio range of T161 may be greater than or equal to 22×6µm/5µm and less than or equal to 22×10µm/5µm;

But it is not limited to this.
one embodiment of the driving circuit shown in FIG. 16 of the present disclosure, when working, controls the potential of the first node Q1 and the potential of the second node QB by using T1-T14, controls the carry output terminal CR to output a carry signal by using T15 and T16, controls O1 to output a first drive signal by using T161 and T171, controls O2 to output a second drive signal by using T162 and T172, controls O3 to output a third drive signal by using T163 and T173, controls O4 to output a fourth drive signal by using T164 and T174, and provides a four-level drive signal by using only twenty-four transistors, increases the vertical layout space of the driving module by four times, has more space for signal connection, saves horizontal space, and reduces the frame. In the related driving circuit, it is necessary to provide four-level drive signals by using four-level drive signals respectively, and seventy-two transistors are required, which is not conducive to layout.

In one embodiment of a multi-stage driving circuit as shown in FIG16, in adjacent driving circuits, the first clock signal provided by the first clock signal terminal and the second clock signal provided by the second clock signal terminal are interchanged.

In one embodiment of the driving circuit shown in FIG.16 can be configured to provide a four-level second scanning signal or a four-level third scanning signal.

In one embodiment of the driving circuit shown in FIG.16, a first capacitor with a larger capacitance value and a second capacitor with a larger capacitance value are used. The single large capacitor design can save layout space on the one hand, and on the other hand, the large capacitor has a stronger noise resistance capability. Since the first node and the second node in the floating state are susceptible to signal disturbances, the large capacitor is designed as much as possible within a limited space to reduce noise.

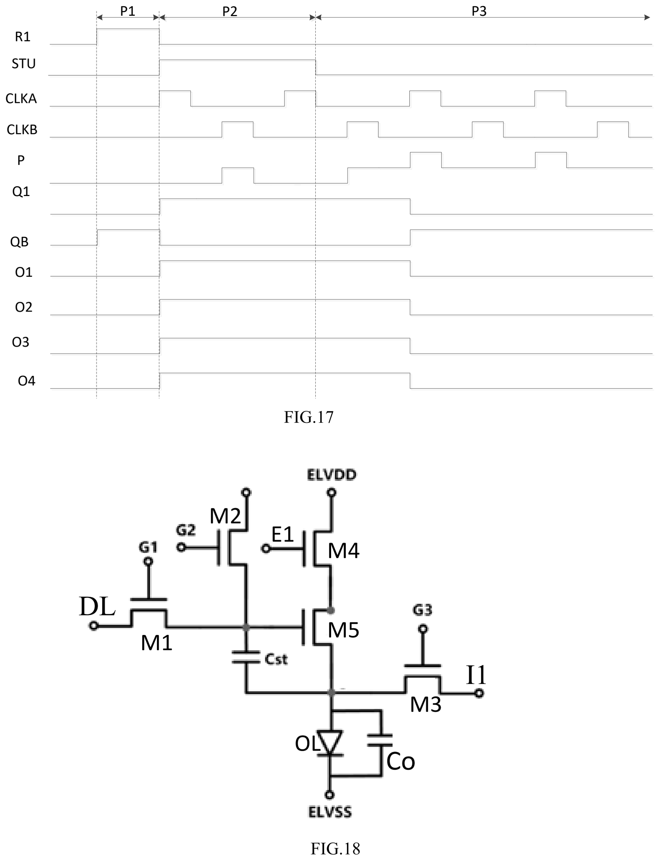

As shown in Fig.17, when one embodiment of the driving circuit shown in FIG. 16 is in operation,

In the first stage P1, R1 provides a high voltage signal, STU provides a low voltage signal, CLKA provides a low voltage signal, CLKB provides a low voltage signal, T5 and T10 are both turned on, T6 is turned on, the potential of Q and the potential of Q1 are both low voltage, T161, T162, T163 and T164 are all turned off; the potential of QB is high voltage, T171, T172, T173 and T174 are all turned on, T16 is turned on, O1, O2, O3 and O4 all output low voltage signals, and CR outputs a low voltage signal;

In the second stage P2, R1 provides a low voltage signal, STU provides a high voltage signal, and T2, T12, and T13 are all turned on;

In the second phase P2, when CLKA provides a high voltage signal, CLKB provides a low voltage signal, T1 is turned on, the potential of Q is a high voltage, T6 is turned on, the potential of Q1 is a high voltage, T161, T162, T163 and T164 are all turned on, T15 is turned on, O1, O2, O3 and O4 all output high voltage signals, and CR outputs a high voltage signal;

In the second stage P2, when CLKB provides a high voltage signal, CLKA provides a low voltage signal, T11 is turned on, T12 and T13 are both turned on, the potential of P is a high voltage, T7 is turned on, the potential of N4 is a low voltage, T4 is turned off, T1 is turned off, the potential of Q is maintained at a high voltage, T6 is turned on, the potential of Q1 is maintained at a high voltage, T9 is turned on, QB is connected to VGL1, the potential of QB is a low voltage, O1, O2, O3 and O4 all output high voltage signals, and CR outputs a high voltage signal;

In the third phase P3, STU provides a low voltage signal;

In the third phase P3, when CLKB provides a high voltage signal, CLKA provides a low voltage signal, T11 is turned on, the potential of P is a high voltage, T4 is turned off, T1 and T2 are turned off, T6 is turned on, the potential of Q and the potential of Q1 are maintained at a high voltage, T9 is turned on, QB is connected to VGL1, the potential of QB is a low voltage, O1, O2, O3 and O4 all output high voltage signals, and CR outputs a high voltage signal;

In the third phase P3, when the potential of the first clock signal provided by CLKA is increased from a low voltage to a high voltage, T7 is turned on, N4 is connected to CLKA, the potential of P is bootstrapped, T3 and T4 are turned on, the potential of Q is a low voltage, T8 is turned on, the potential of QB is a high voltage, T171, T172, T173 and T174 are all turned on, T16 is turned on, O1, O2, O3 and O4 all output low voltage signals, and CR outputs a low voltage signal;

In the third stage P3, when CLKB provides a high voltage signal, CLKA provides a low voltage signal, T11 is turned on, P is connected to VGH, T4 is turned off, T1 is turned off, T6 is turned on, the potential of Q and the potential of Q1 are both maintained at a low voltage, T8 and T9 are turned off, the potential of QB is maintained at a high voltage, T171, T172, T173 and T174 are all turned on, T16 is turned on, O1, O2, O3 and O4 all output low voltage signals, and CR outputs a low voltage signal.

As shown in Fig.18, one embodiment of the pixel circuit includes a data writing transistor M1, a reference voltage writing transistor M2, an initialization transistor M3, a light emission control transistor M4, a driving transistor M5, a storage capacitor Cst and an organic light emitting diode OL;

The gate of M1 is electrically connected to the first scan line G1, the drain of M1 is electrically connected to the data line DL, and the source of M1 is electrically connected to the gate of M5; the first scan line G1 is configured to provide a first scan signal;

The gate of M2 is electrically connected to the second scan line G2, the drain of M2 is electrically connected to the reference voltage terminal VR, and the source of M2 is electrically connected to the gate of M5; the second scan line G2 is configured to provide a second scan signal;

The gate of M3 is electrically connected to the third scan line G3, the drain of M3 is electrically connected to the initial voltage terminal I1, and the source of M3 is electrically connected to the anode of OL; the third scan line G3 is configured to provide a third scan signal; the initial voltage terminal I1 is configured to provide an initial voltage Vini;

The gate of M4 is electrically connected to the light-emitting control line E1, the drain of M4 is electrically connected to the power supply voltage terminal ELVDD, and the source of M4 is electrically connected to the drain of M5; the light-emitting control line E1 is configured to provide a light-emitting control signal;

The source of M5 is electrically connected to the anode of OL; the cathode of O1 is electrically connected to the low level terminal ELVSS;

The first electrode plate of Cst is electrically connected to the gate of M5, and the second electrode plate of Cst is electrically connected to the source of M5.

In FIG18, Co is a light emission control capacitor.

In FIG. 18, all transistors are n-type transistors, but the present invention is not limited thereto.

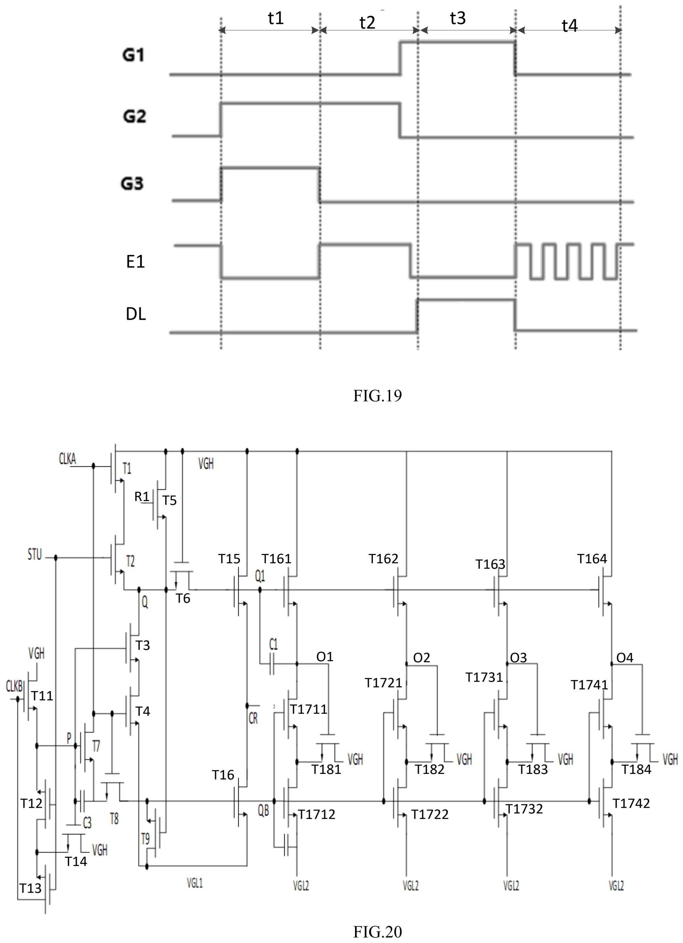

Fig.19 is working time sequence in one embodiment of the pixel circuit shown in FIG. 18.

When one embodiment of the pixel circuit shown in FIG. 18 is in operation, a display cycle may include a reset phase t1, a compensation phase t2, a data writing phase t3, and a light emitting phase t4, which are arranged in sequence;

In the reset phase t1, G1 provides a low voltage signal, G2 provides a high voltage signal, G3 provides a high voltage signal, E1 provides a low voltage signal, DL provides a reference voltage Vref, M2 and M3 are turned on to write Vref into the gate of M5, write Vini into the anode of OL to control OL not to emit light and clear the residual charge of the anode of OL;

In the compensation stage t2, G1 provides a low voltage signal, G2 provides a high voltage signal, G3 provides a low voltage signal, E1 provides a high voltage signal, DL provides a reference voltage Vref, M2 is turned on, and M4 is turned on;

At the beginning of the compensation phase t2, M5 is turned on to charge Cst to control the potential of the source of M5 until the source potential of M5 becomes Vref-Vth, and M5 is turned off, where Vth is the threshold voltage of M5;

In the data writing phase t3, G1 provides a high voltage signal, G2, G3 and E1 all provide low voltage signals, M1 is turned on, and DL provides a data voltage Vdata to the gate of M5;

In the light-emitting stage t4, G1, G2 and G3 all provide low voltage signals, EM provides a high-frequency voltage signal, and when E1 provides a high voltage signal, M5 drives OL to emit light.

In at least one embodiment of the present disclosure, the structure of the pixel circuit included in the display device is not limited to that shown in FIG. 18, and the waveforms of each scanning signal and the waveform of the light emitting control signal are not limited to that shown in FIG. 19.

As shown in Fig.20, based on one embodiment of the driving circuit shown in FIG.13, the first node control circuit includes a first transistor T1, a second transistor T2, a third transistor T3, a fourth transistor T4, a fifth transistor T5 and a sixth transistor T6;

The gate of the first transistor T1 is electrically connected to the first clock signal terminal CLKA, the drain of the first transistor T1 is electrically connected to the high voltage terminal VGH, and the source of the first transistor T1 is electrically connected to the drain of the second transistor T2;

The gate of the second transistor T2 is electrically connected to the input terminal STU, and the source of the second transistor T2 is electrically connected to the intermediate node Q;

The gate of the third transistor T3 is electrically connected to the third node P, the drain of the third transistor T3 is electrically connected to the intermediate node Q, and the source of the third transistor T3 is electrically connected to the drain of the fourth transistor T4;

The gate of the fourth transistor T4 is electrically connected to the first clock signal terminal CLKA, and the source of the fourth transistor T4 is electrically connected to the first low voltage terminal VGL1; the fifth voltage terminal may be the first low voltage terminal VGL1;

The gate of the fifth transistor T5 is electrically connected to the reset terminal R1, the drain of the fifth transistor T5 is electrically connected to the first clock signal terminal CLKA, and the source of the fifth transistor T5 is electrically connected to the intermediate node Q;

The gate of the sixth transistor T6 is electrically connected to the high voltage terminal VGH, the drain of the sixth transistor T6 is electrically connected to the intermediate node Q, and the source of the sixth transistor T6 is electrically connected to the first node Q1; the fourth voltage terminal may be the high voltage terminal VGH;

The second node control circuit includes a seventh transistor T7, an eighth transistor T8 and a ninth transistor T9;

The gate of the seventh transistor T7 is electrically connected to the third node P, the drain of the seventh transistor T7 is electrically connected to the first clock signal terminal CLKA, and the source of the seventh transistor T7 is electrically connected to the fourth node N4;

The gate of the eighth transistor T8 is electrically connected to the first clock signal terminal CLKA, the drain of the eighth transistor T8 is electrically connected to the fourth node N4, and the source of the eighth transistor T8 is electrically connected to the second node QB;

The gate of the ninth transistor T9 is electrically connected to the first node Q1, the drain of the ninth transistor T9 is electrically connected to the second node QB, and the source of the ninth transistor T9 is electrically connected to the first low voltage terminal VGL1;

The third node control circuit includes an eleventh transistor T11, a twelfth transistor T12, a thirteenth transistor T13, a fourteenth transistor T14 and a third capacitor C3;

The gate of the eleventh transistor T11 is electrically connected to the second clock signal terminal CLKB, the drain of the eleventh transistor T11 is electrically connected to the high voltage terminal VGH, and the source of the eleventh transistor T11 is electrically connected to the third node P;

The gate of the twelfth transistor T12 is electrically connected to the input terminal STU, the drain of the twelfth transistor T12 is electrically connected to the third node P, and the source of the twelfth transistor T12 is electrically connected to the fifth node N5;

The gate of the thirteenth transistor T13 is electrically connected to the input terminal STU, the drain of the thirteenth transistor T13 is electrically connected to the fifth node N5, and the source of the thirteenth transistor T13 is electrically connected to the second clock signal terminal CLKB;

The gate of the fourteenth transistor T14 is electrically connected to the third node P, the drain of the fourteenth transistor T14 is electrically connected to the high voltage terminal VGH, and the source of the fourteenth transistor T14 is electrically connected to the fifth node N5;

The first electrode plate of the third capacitor C3 is electrically connected to the third node P, and the second electrode plate of the third capacitor C3 is electrically connected to the fourth node N4;

The carry output circuit includes a fifteenth transistor T15 and a sixteenth transistor T16;

The gate of the fifteenth transistor T15 is electrically connected to the first node Q1, the drain of the fifteenth transistor T15 is electrically connected to the high voltage terminal VGH, and the source of the fifteenth transistor T15 is electrically connected to the carry output terminal CR;

The gate of the sixteenth transistor T16 is electrically connected to the second node QB, the drain of the sixteenth transistor T16 is electrically connected to the carry output terminal CR, and the source of the sixteenth transistor T16 is electrically connected to the first low voltage terminal VGL1;

The first energy storage circuit includes a first capacitor C1, and the second energy storage circuit includes a second capacitor C2;

The first electrode plate of the first capacitor C1 is electrically connected to the first node Q1, and the second electrode plate of the first capacitor C1 is electrically connected to the first driving output terminal O1;

A first electrode plate of the second capacitor C2 is electrically connected to the second node QB, and a second electrode plate of the second capacitor C2 is electrically connected to the second low voltage terminal VGL2;

The first output circuit includes a first output transistor T161;

The second output circuit includes a second output transistor T162;

The third output circuit includes a third output transistor T163;

The fourth output circuit includes a fourth output transistor T164;

The gate of T161 is electrically connected to the first node Q1, the drain of T161 is electrically connected to the high voltage terminal VGH, and the source of T161 is electrically connected to the first driving output terminal O1;

The gate of T162 is electrically connected to the first node Q1, the drain of T162 is electrically connected to the high voltage terminal VGH, and the source of T162 is electrically connected to the second driving output terminal O2;

The gate of T163 is electrically connected to the first node Q1, the drain of T163 is electrically connected to the high voltage terminal VGH, and the source of T163 is electrically connected to the third driving output terminal O3;

The gate of T164 is electrically connected to the first node Q1, the drain of T164 is electrically connected to the high voltage terminal VGH, and the source of T164 is electrically connected to the fourth driving output terminal O4;

The first first output reset sub-circuit includes a first first output reset transistor T1711, and the first second output reset sub-circuit includes a first second output reset transistor T1712;

The second first output reset sub-circuit includes a second first output reset transistor T1721, the second second output reset sub-circuit includes a second second output reset transistor T1722;

The third first output reset sub-circuit includes a third first output reset transistor T1713, and the third second output reset sub-circuit includes a third second output reset transistor T1732;

The fourth first output reset sub-circuit includes a fourth first output reset transistor T1741, the fourth second output reset sub-circuit includes a fourth second output reset transistor T1742;

The first setting circuit includes a first setting transistor T181, the second setting circuit includes a second setting transistor T182, the third setting circuit includes a third setting transistor T183, and the fourth setting circuit includes a fourth setting transistor T184;

The gate of T1711 is electrically connected to the second node QB, the drain of T1711 is electrically connected to the first driving output terminal O1, and the source of T1711 is electrically connected to the first output node;

The gate of T1712 is electrically connected to the second node QB, the drain of T1712 is electrically connected to the first output node, and the source of T1712 is electrically connected to the second low voltage terminal VGL2; the second voltage terminal is the second low voltage terminal VGL2;

The gate of T181 is electrically connected to the first driving output terminal O1, the drain of T181 is electrically connected to the first output node, and the source of T181 is electrically connected to the high voltage terminal VGH; the third voltage terminal is the high voltage terminal VGH;

The gate of T1721 is electrically connected to the second node QB, the drain of T1721 is electrically connected to the second driving output terminal O2, and the source of T1721 is electrically connected to the second output node;

The gate of T1722 is electrically connected to the second node QB, the drain of T1722 is electrically connected to the second output node, and the source of T1722 is electrically connected to the second low voltage terminal VGL2;

The gate of T182 is electrically connected to the second driving output terminal O2, the drain of T182 is electrically connected to the second output node, and the source of T182 is electrically connected to the high voltage terminal VGH;

The gate of T1731 is electrically connected to the second node QB, the drain of T1731 is electrically connected to the third driving output terminal O3, and the source of T1731 is electrically connected to the third output node;

The gate of T1732 is electrically connected to the second node QB, the drain of T1732 is electrically connected to the third output node, and the source of T1732 is electrically connected to the second low voltage terminal VGL2;

The gate of T183 is electrically connected to the third driving output terminal O3, the drain of T183 is electrically connected to the third output node, and the source of T183 is electrically connected to the high voltage terminal VGH;

The gate of T1741 is electrically connected to the second node QB, the drain of T1741 is electrically connected to the fourth driving output terminal O4, and the source of T1741 is electrically connected to the fourth output node;

The gate of T1742 is electrically connected to the second node QB, the drain of T1742 is electrically connected to the fourth output node, and the source of T1742 is electrically connected to the second low voltage terminal VGL2;

The gate of T184 is electrically connected to the fourth driving output terminal O4, the drain of T184 is electrically connected to the fourth output node, and the source of T184 is electrically connected to the high voltage terminal VGH.

In at least one embodiment of the driving circuit shown in FIG. 20, all transistors are n-type transistors, but the present invention is not limited thereto.

In at least one embodiment of the driving circuit shown in FIG. 20 may be configured to provide a four-level light emitting control signal.

In at least one embodiment of the driving circuit shown in FIG20, a first capacitor with a larger capacitance value and a second capacitor with a larger capacitance value are used. The single large capacitor design can save layout space on the one hand, and on the other hand, the large capacitor has a stronger anti- noise capability. Since the first node and the second node in the floating state are susceptible to signal disturbances, the large capacitor is designed as much as possible within a limited space to reduce noise.

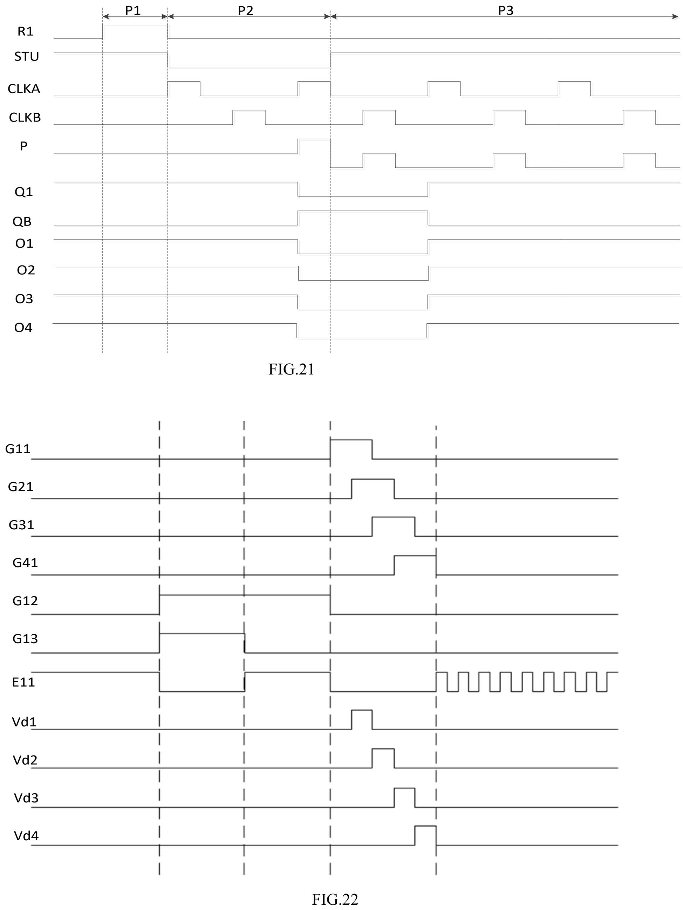

As shown in Fig.21, one embodiment of the driving circuit shown in FIG. 20 is in operation,

In the first stage P1, R1 provides a high voltage signal, STU provides a high voltage signal, T5 is turned on, the potential of Q is high voltage, T6 is turned on, the potential of Q1 is high voltage, T9 is turned on, the potential of QB is low voltage, T161, T162, T163 and T164 are all turned on, O1 outputs a high voltage signal, O2 outputs a high voltage signal, O3 outputs a high voltage signal, and O4 outputs a high voltage signal; T15 is turned on, and CR outputs a high voltage signal;

In the first stage P1, T181, T182, T183 and T184 are all turned on, NO1, NO2, NO3 and NO4 are all connected to VGH, and the potentials of NO1, NO2, NO3 and NO4 are all high voltages, so that the potentials of O1, O2, O3 and O4 will not be pulled down due to leakage;

In the second phase P2, STU provides a low voltage signal and R1 provides a low voltage signal;

In the second phase P2, when CLKB provides a high voltage signal, T11 is turned on and the potential of P is a high voltage;

In the second phase P2, after CLKB provides a high voltage signal, when the potential of the first clock signal provided by CLKA rises from a low voltage to a high voltage, T7 is turned on, and the potential of P is bootstrapped; T3 and T4 are both turned on, the potential of Q is a low voltage, T8 is turned on, and the potential of QB is a high voltage; T1711, T1712, T1721, T1722, T1731, T1732, T1741 and T1742 are all turned on, O1 outputs a low voltage signal, O2 outputs a low voltage signal, O3 outputs a low voltage signal, and O4 outputs a low voltage signal; T16 is turned on, and CR outputs a low voltage signal;

In the third stage P3, STU provides a high voltage signal and R1 provides a low voltage signal. When CLKA provides a high voltage signal, T1 and T2 are turned on, the potential of Q is a high voltage, T6 is turned on, the potential of Q1 is a high voltage, T9 is turned on, the potential of QB is a low voltage, T161, T162, T163 and T164 are all turned on, O1 outputs a high voltage signal, O2 outputs a high voltage signal, O3 outputs a high voltage signal, and O4 outputs a high voltage signal; T15 is turned on, and CR outputs a high voltage signal; T181, T182, T183 and T184 are all turned on, NO1, NO2, NO3 and NO4 are all connected to VGH, and the potentials of NO1, NO2, NO3 and NO4 are all high voltages, so that the potentials of O1, O2, O3 and O4 will not be pulled down due to leakage.

FIG.22 is a timing diagram of a common driving circuit of at least one embodiment of the 5T2C pixel circuit shown in FIG18 in four rows, wherein G11 is a signal provided by the first scan line of the first row, G21 is a signal provided by the first scan line of the second row, G31 is a signal provided by the first scan line of the third row, and G41 is a signal provided by the first scan line of the fourth row and a signal provided by G11;

The signal marked G12 is provided by the second scan line in the first row, and the signal provided by the second scan line in the second row, the signal provided by the second scan line in the third row, and the signal provided by the second scan line in the fourth row are the same as the signal provided by G12;

The signal marked G13 is provided by the third scan line in the first row, and the signal provided by the third scan line in the second row, the signal provided by the third scan line in the third row, and the signal provided by the third scan line in the fourth row are the same as the signal provided by G13;

The signal marked E11 is provided by the first row of light-emitting control lines, the signal provided by the second row of light-emitting control lines, the signal provided by the third row of light-emitting control lines, and the signal provided by the fourth row of light-emitting control lines are the same;

In FIG. 22, the voltage labeled Vd1 is the first data voltage, the voltage labeled Vd2 is the second data voltage, the voltage labeled Vd3 is the third data voltage, and the voltage labeled Vd4 is the fourth data voltage;

The four rows of pixel circuits are connected to the same second scanning signal, the same third scanning signal and the same light-emitting control signal, the four rows of pixel circuits are reset and threshold voltage compensated simultaneously, the four rows of pixel circuits are written with data voltages successively, and after the data voltages are written, the four rows of pixel circuits emit light simultaneously.

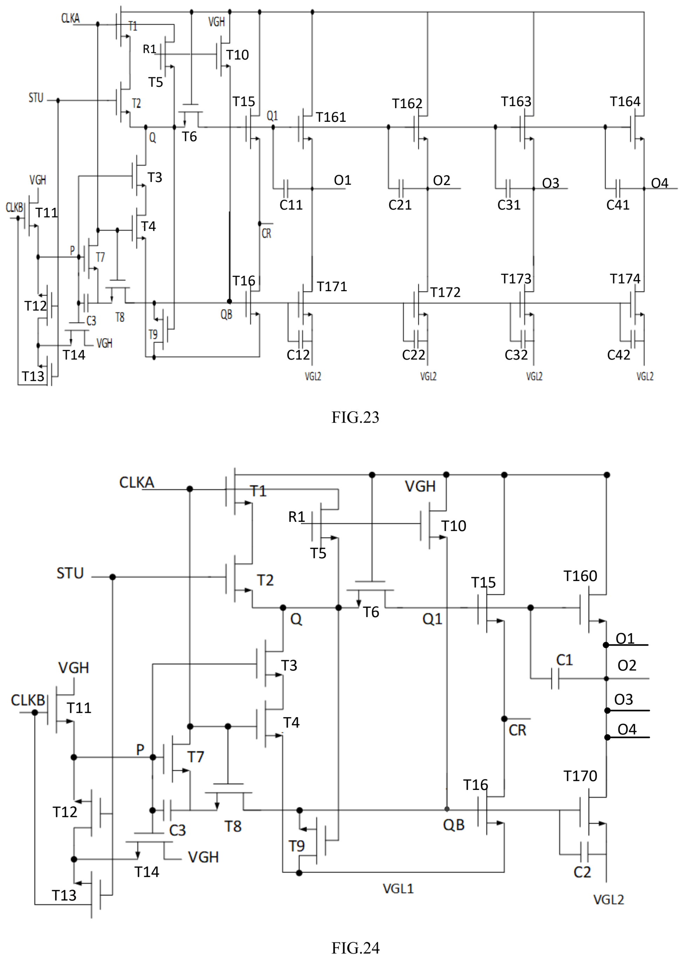

The difference between at least one embodiment of the driving circuit shown in FIG.23 and at least one embodiment of the driving circuit shown in FIG. 16 is as follows:

The difference between at least one embodiment of the driving circuit shown in FIG.23 includes a first first capacitor C11, a second first capacitor C21, a third first capacitor C31, a fourth first capacitor C41, a first second capacitor C12, a second second capacitor C22, a third second capacitor C32 and a fourth second capacitor C42;

The first electrode of C11 is electrically connected to the first node Q1, and the second terminal of C11 is electrically connected to O1;

The first electrode plate of C21 is electrically connected to the first node Q1, and the second terminal of C21 is electrically connected to O2;

The first electrode of C31 is electrically connected to the first node Q1, and the second terminal of C31 is electrically connected to O3;

The first electrode plate of C41 is electrically connected to the first node Q1, and the second terminal of C41 is electrically connected to O4;

The first electrode plate of C12 is electrically connected to the second node QB, and the second electrode plate of C12 is electrically connected to the source electrode of T171;

The first electrode plate of C22 is electrically connected to the second node QB, and the second electrode plate of C22 is electrically connected to the source electrode of T172;

The first electrode of C32 is electrically connected to the second node QB, and the second electrode of C32 is electrically connected to the source of T173;

The first electrode plate of C42 is electrically connected to the second node QB, and the second electrode plate of C42 is electrically connected to the source of T174.

In at least one embodiment of the driving circuit shown in FIG. 23, the capacitance value of C11 may be greater than or equal to 0.5 pF and less than or equal to 1 pF;

The capacitance value of C12 can be greater than or equal to 75fF and less than or equal to 125fF;

But it is not limited to this.

In at least one embodiment of the driving circuit shown in FIG. 23, four first capacitors and four second capacitors are configured to ensure that each driving output terminal has a capacitor to ensure that the potential is not disturbed by other signals.

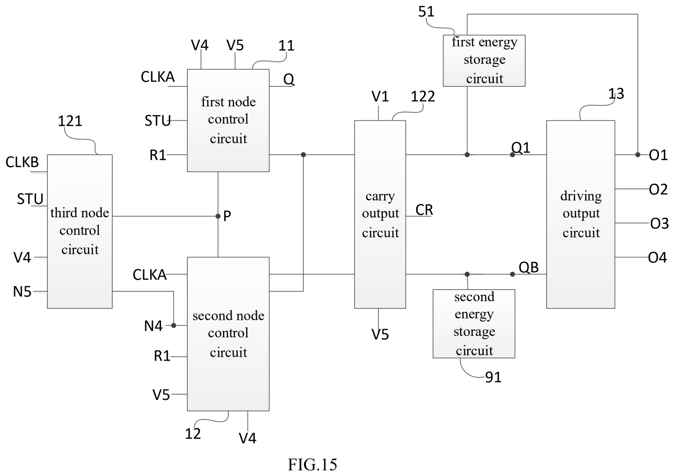

In at least one embodiment of the driving circuit shown in FIG. 15, the first node control circuit includes a first transistor T1, a second transistor T2, a third transistor T3, a fourth transistor T4, a fifth transistor T5 and a sixth transistor T6;

The gate of the first transistor T1 is electrically connected to the first clock signal terminal CLKA, the drain of the first transistor T1 is electrically connected to the high voltage terminal VGH, and the source of the first transistor T1 is electrically connected to the drain of the second transistor T2;

The gate of the second transistor T2 is electrically connected to the input terminal STU, and the source of the second transistor T2 is electrically connected to the intermediate node Q;

The gate of the third transistor T3 is electrically connected to the third node P, the drain of the third transistor T3 is electrically connected to the intermediate node Q, and the source of the third transistor T3 is electrically connected to the drain of the fourth transistor T4;

The gate of the fourth transistor T4 is electrically connected to the first clock signal terminal CLKA, and the source of the fourth transistor T4 is electrically connected to the first low voltage terminal VGL1; the fifth voltage terminal may be the first low voltage terminal VGL1;

The gate of the fifth transistor T5 is electrically connected to the reset terminal R1, the drain of the fifth transistor T5 is electrically connected to the first clock signal terminal CLKA, and the source of the fifth transistor T5 is electrically connected to the intermediate node Q;

The gate of the sixth transistor T6 is electrically connected to the high voltage terminal VGH, the drain of the sixth transistor T6 is electrically connected to the intermediate node Q, and the source of the sixth transistor T6 is electrically connected to the first node Q1; the fourth voltage terminal may be the high voltage terminal VGH;

The second node control circuit includes a seventh transistor T7, an eighth transistor T8 and a ninth transistor T9;

The gate of the seventh transistor T7 is electrically connected to the third node P, the drain of the seventh transistor T7 is electrically connected to the first clock signal terminal CLKA, and the source of the seventh transistor T7 is electrically connected to the fourth node N4;

The gate of the eighth transistor T8 is electrically connected to the first clock signal terminal CLKA, the drain of the eighth transistor T8 is electrically connected to the fourth node N4, and the source of the eighth transistor T8 is electrically connected to the second node QB;

The gate of the ninth transistor T9 is electrically connected to the first node Q1, the drain of the ninth transistor T9 is electrically connected to the second node QB, and the source of the ninth transistor T9 is electrically connected to the first low voltage terminal VGL1;

The second node control circuit further includes a tenth transistor T10;

The gate of the tenth transistor T10 is electrically connected to the reset terminal R1, the drain of the tenth transistor T10 is electrically connected to the second node QB, and the source of the tenth transistor T10 is electrically connected to the high voltage terminal VGH;

The third node control circuit includes an eleventh transistor T11, a twelfth transistor T12, a thirteenth transistor T13, a fourteenth transistor T14 and a third capacitor C3;

The gate of the eleventh transistor T11 is electrically connected to the second clock signal terminal CLKB, the drain of the eleventh transistor T11 is electrically connected to the high voltage terminal VGH, and the source of the eleventh transistor T11 is electrically connected to the third node P;

The gate of the twelfth transistor T12 is electrically connected to the input terminal STU, the drain of the twelfth transistor T12 is electrically connected to the third node P, and the source of the twelfth transistor T12 is electrically connected to the fifth node N5;

The gate of the thirteenth transistor T13 is electrically connected to the input terminal STU, the drain of the thirteenth transistor T13 is electrically connected to the fifth node N5, and the source of the thirteenth transistor T13 is electrically connected to the second clock signal terminal CLKB;

The gate of the fourteenth transistor T14 is electrically connected to the third node P, the drain of the fourteenth transistor T14 is electrically connected to the high voltage terminal VGH, and the source of the fourteenth transistor T14 is electrically connected to the fifth node N5;

The first electrode plate of the third capacitor C3 is electrically connected to the third node P, and the second electrode plate of the third capacitor C3 is electrically connected to the fourth node N4;

The carry output circuit includes a fifteenth transistor T15 and a sixteenth transistor T16;

the fifteenth transistor T15 is electrically connected to the first node Q1, the drain of the fifteenth transistor T15 is electrically connected to the high voltage terminal VGH, and the source of the fifteenth transistor T15 is electrically connected to the carry output terminal CR;

The gate of the sixteenth transistor T16 is electrically connected to the second node QB, the drain of the sixteenth transistor T16 is electrically connected to the carry output terminal CR, and the source of the sixteenth transistor T16 is electrically connected to the first low voltage terminal VGL1;

The first energy storage circuit includes a first capacitor C1, and the second energy storage circuit includes a second capacitor C2;

The first electrode plate of the first capacitor C1 is electrically connected to the first node Q1, and the second electrode plate of the first capacitor C1 is electrically connected to the first driving output terminal O1;

A first electrode plate of the second capacitor C2 is electrically connected to the second node QB, and a second electrode plate of the second capacitor C2 is electrically connected to the second low voltage terminal VGL2;

The driving output circuit 13 includes an output transistor T160 and an output reset transistor T170;

The gate of T160 is electrically connected to the first node Q1, the drain of T160 is electrically connected to the high voltage terminal VGH, and the source of T160 is electrically connected to the first driving output terminal O1, the second driving output terminal O2, the third driving output terminal O3 and the fourth driving output terminal O4 respectively; the first voltage terminal is the high voltage terminal VGH;

The gate of T170 is electrically connected to the second node QB, the drain of T170 is electrically connected to the first driving output terminal O1, the second driving output terminal O2, the third driving output terminal O3 and the fourth driving output terminal O4 respectively, the source of T171 is electrically connected to the second low voltage terminal VGL2; the second voltage terminal is the second low voltage terminal VGL2.

In at least one embodiment of the driving circuit shown in FIG. 24, the channel width-to-length ratio of T160 may be greater than or equal to 22×32µm/5µm and less than or equal to 22×48µm/5µm, and the channel width-to-length ratio of T170 may be greater than or equal to 22×24µm/5µm and less than or equal to 22×40µm/5µm, but are not limited thereto.

In at least one embodiment of the driving circuit shown in FIG. 24, all transistors are n-type transistors, but the present invention is not limited thereto.

In at least one embodiment of the driving circuit shown in Figure 24, the four driving output terminals share an output transistor T160 and an output reset transistor T170, that is, T160 is electrically connected to the four driving output terminals at the same time, and T170 is electrically connected to the four driving output terminals at the same time. Here, it is assumed that the load of a row of scanning lines is the first load, and the loads of the four rows of scanning lines are four first loads.

In at least one embodiment of the driving circuit shown in FIG. 16 when the width-to-length ratio of each output transistor is the first width-to-length ratio A1 and the width-to-length ratio of each output reset transistor is the second width-to-length ratio A2;

In at least one embodiment of the driving circuit shown in FIG. 24 when the width-to-length ratio of the output transistor is the first width-to-length ratio A1 and the width-to-length ratio of the output reset transistor is the second width-to-length ratio A2.

In at least one embodiment of the driving circuit shown in FIG. 24 when the width-to-length ratio of the output transistor is 4×A1 and the width-to-length ratio of the output reset transistor is 4×A2.

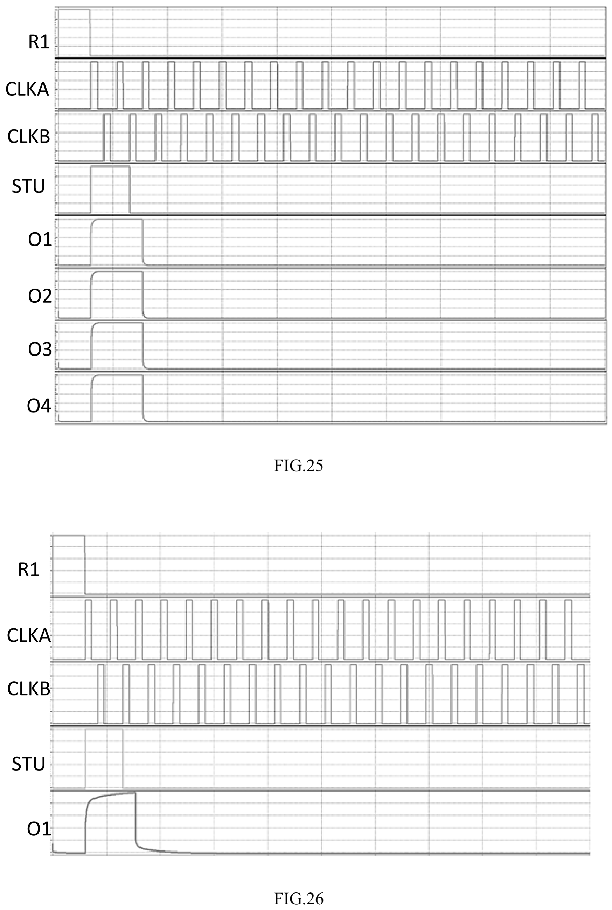

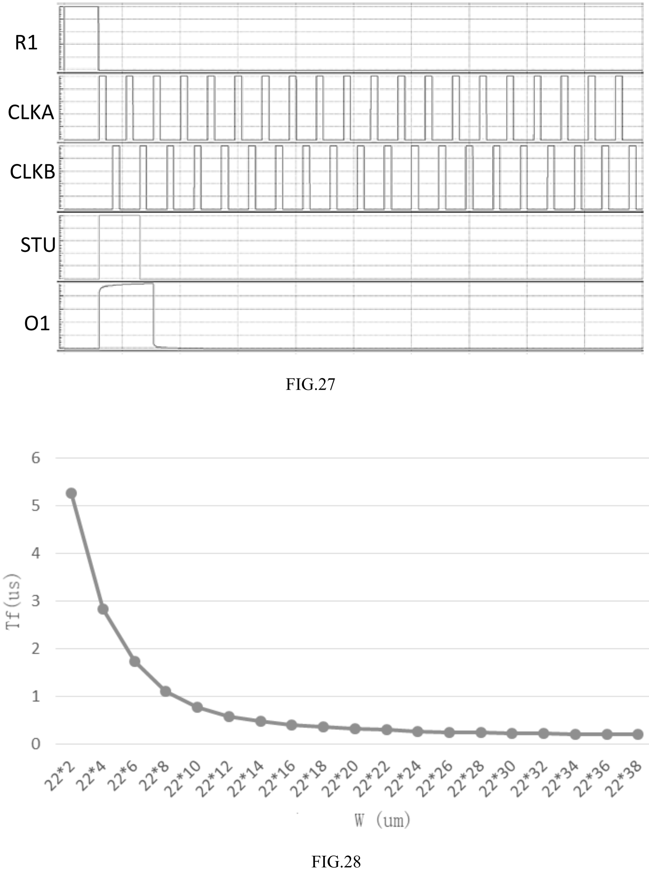

As shown in FIG26, when multiple driving output terminals share an output transistor and an output reset transistor, and the width-to-length ratio of the output transistor and the width-to- length ratio of the output reset transistor are relatively small, the rise time tr of the drive signal output by each driving output terminal and the fall time tf of the drive signal are significantly increased. In order to ensure that the waveform of the drive signal meets the drive requirements, the width-to-length ratio of the output transistor is at least 4×A1, and the width-to-length ratio of the output reset transistor is at least 4×A2. As shown in FIG27, even if the width-to-length ratio of the output transistor and the width-to-length ratio of the output reset transistor are increased by 4 times, the waveform of the drive signal is still different from the separate design. An important reason for this phenomenon is that the working capacity of the output transistor and the working capacity of the output reset transistor are limited. When the width-to-length ratio of the transistor reaches a certain value, even if the size is increased, the working capacity cannot be further improved. On the other hand, the larger the width-to-length ratio of the transistor, the greater the current flowing through the transistor, and the easier it is to cause the transistor to burn out. In a traditional GOA (Gate On Array, array substrate row drive) circuit, the size of the output transistor and the size of the output reset transistor are relatively large. If multiple rows share the output transistor and the output reset transistor, it is easy to reach the limit value of the transistor size that is prone to burn out.

Figure 28 is a schematic diagram showing the relationship between the channel width W of the output reset transistor and the falling time Tf of the driving signal. From Figure 28, when the channel width of the output reset transistor increases to 22×20 µm, Tf no longer changes significantly. At this time, the channel length of the output reset transistor can be 5 µm.

The driving method described in the embodiment of the present disclosure is applied to the above-mentioned driving circuit, and the driving method includes:
A first node control circuit controls the potential of the first node;
The second node control circuit controls the potential of the second node;
to output the n-th driving signal under the control of the potential of the first node and the potential of the second node;
N is an integer greater than 1; n is a positive integer less than or equal to N.
the present disclosure includes the above-mentioned driving circuit.

In at least one embodiment of the present disclosure, the driving circuit includes a second energy storage circuit; the second energy storage circuit is electrically connected to the second node, and the second energy storage circuit is configured to store electric energy; the second energy storage circuit includes a second capacitor; the display substrate further includes N-1 pseudo capacitors;

The second capacitor and the N-1 pseudo capacitors are arranged along a first direction

The first electrode plate of the pseudo capacitor is electrically connected to the second electrode plate of the pseudo capacitor.

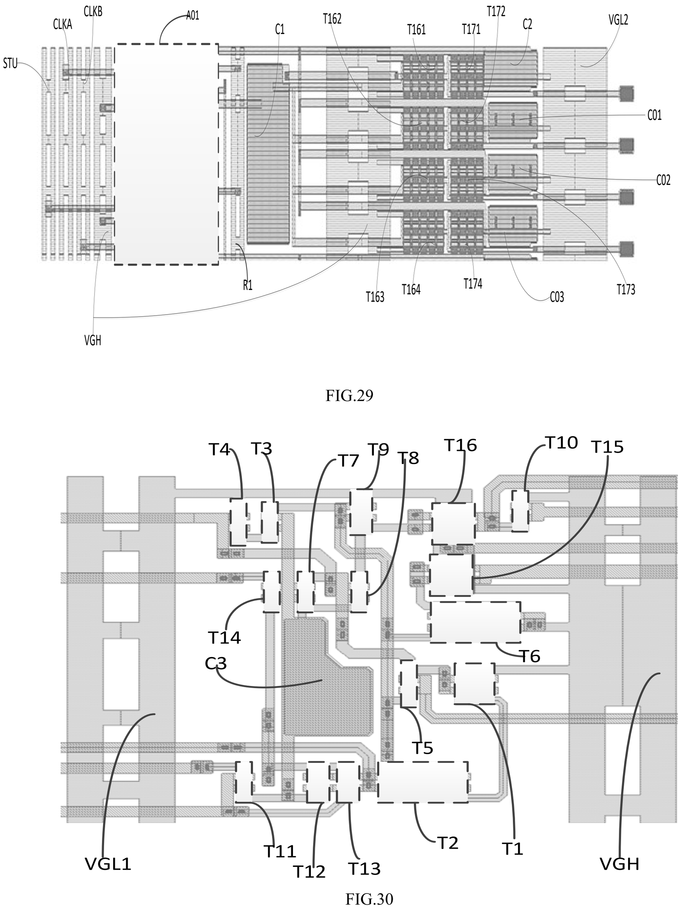

Fig.29 is layout diagram of one embodiment of the driving circuit shown in FIG. 16.

In at least one embodiment shown in FIG. 29, only one second capacitor C2 is used, but a first pseudo capacitor C01, a second pseudo capacitor C02, and a third pseudo capacitor C03 are configured to maintain Layout uniformity;

The first electrode plate of the first pseudo capacitor C01 is electrically connected to the second electrode plate of the first pseudo capacitor C01;

The first electrode plate of the second pseudo capacitor C02 is electrically connected to the second electrode plate of the second pseudo capacitor C02;

The first electrode plate of the third pseudo capacitor C03 is electrically connected to the second electrode plate of the third pseudo capacitor C03.

FIG.30 is an enlarged schematic diagram of the first area A01 in FIG29.

The display device described in the embodiment of the present disclosure includes the above-mentioned driving circuit.

The above is a preferred embodiment of the present disclosure. It should be pointed out that for ordinary technicians in this technical field, several improvements and modifications can be made without departing from the principles described in the present disclosure. These improvements and modifications should also be regarded as the scope of protection of the present disclosure.

## Claims

1. A driving circuit, comprising N driving output terminals, a first node control circuit, a second node control circuit and a driving output circuit;
the first node control circuit is electrically connected to a first node and is configured to control a potential of the first node;
the second node control circuit is electrically connected to a second node and is configured to control a potential of the second node;
the driving output circuit is electrically connected to the first node, the second node and the N driving output terminals, and is configured to control a n-th driving output terminal to output a n-th driving signal under a control of the potential of the first node and the potential of the second node;
N is an integer greater than 1; n is a positive integer less than or equal to N.

2. The driving circuit according to claim 1, wherein the driving output circuit comprises N driving output units; N is an integer greater than 1;
the n-th driving output unit is electrically connected to the first node, the second node and the n-th driving output terminal, and is configured to control the n-th driving output terminal to output the n-th driving signal under the control of the potential of the first node and the potential of the second node;
n is a positive integer less than or equal to N.

3. The driving circuit according to claim 2, wherein the n-th driving output unit comprises an n-th output circuit and an n-th output reset circuit;
the n-th output circuit is electrically connected to the first node, a n-th first voltage terminal and the n-th driving output terminal, and is configured to control a connection between the n-th driving output terminal and the n-th first voltage terminal under the control of the potential of the first node;
the n-th output reset circuit is electrically connected to the second node, a n-th second voltage terminal and the n-th driving output terminal, and is configured to control a connection between the n-th driving output terminal and the n-th second voltage terminal under the control of the potential of the second node.

4. The driving circuit according to claim 3, wherein the first voltage terminals to which the N driving output units are electrically connected are the same; and/or,
the N driving output units are respectively electrically connected to the same second voltage terminal.

5. The driving circuit according to claim 3, wherein the n-th output reset circuit comprises an n-th first output reset sub-circuit and an n-th second output reset sub-circuit;
the n-th first output reset sub-circuit is electrically connected to the second node, the n-th driving output terminal and the n-th output node, and is configured to control the n-th driving output terminal to be electrically connected to the n-th output node under the control of the potential of the second node;
the n-th second output reset sub-circuit is electrically connected to the second node, the n-th output node and the n-th second voltage terminal, and is configured to control a connection between the n-th output node and the n-th second voltage terminal under the control of the potential of the second node;
the n-th driving output unit further comprises an n-th setting circuit;
the n-th setting circuit is electrically connected to the n-th driving output terminal, the n-th output node and the third voltage terminal, and is configured to control the connection between the n-th output node and the third voltage terminal under a control of the n-th driving signal provided by the n-th driving output terminal.

6. The driving circuit according to any one of claims 1 to 5, further comprising a first energy storage circuit; wherein
a first terminal of the first energy storage circuit is electrically connected to the first node, a second terminal of the first energy storage circuit is electrically connected to one of the N driving output terminals, and the first energy storage circuit is configured to store electrical energy.

7. The driving circuit according to any one of claims 1 to 5, further comprising at least two first energy storage circuits;
first terminals of the at least two first energy storage circuits are electrically connected to the first node, second terminals of the at least two first energy storage circuits are electrically connected to at least two of the driving output terminals, and the first energy storage circuits are configured to store electrical energy.

8. The driving circuit according to any one of claims 1 to 5, further comprising a second energy storage circuit;
the second energy storage circuit is electrically connected to the second node, and the second energy storage circuit is configured to store electrical energy.

9. The driving circuit according to claim 3, wherein a control terminal of the n-th output reset circuit is electrically connected to the second node, the first terminal of the n-th output reset circuit is electrically connected to the n-th driving output terminal, and the second terminal of the n-th output reset circuit is electrically connected to the n-th second voltage terminal;
the driving circuit further comprises at least two second energy storage circuits;
the first terminal of the second energy storage circuit is electrically connected to the second node, and the second terminal of the second energy storage circuit is electrically connected to the second terminal of one of the N output reset circuits; the second energy storage circuit is configured to store electrical energy.

10. The driving circuit according to claim 3, wherein the n-th output circuit comprises an n-th output transistor, and the n-th output reset circuit comprises an n-th output reset transistor;
a gate of the n-th output transistor is electrically connected to the first node, a first electrode of the n-th output transistor is electrically connected to the n-th first voltage terminal, and a second electrode of the n-th output transistor is electrically connected to the n-th driving output terminal;
a gate of the n-th output reset transistor is electrically connected to the second node, a first electrode of the n-th output reset transistor is electrically connected to the n-th driving output terminal, and the second electrode of the n-th output reset transistor is electrically connected to the n-th second voltage terminal.

11. The driving circuit according to claim 5, wherein the n-th first output reset sub-circuit comprises an n-th first output reset transistor, the n-th second output reset sub-circuit comprises an n-th second output reset transistor, and the n-th set circuit comprises an n-th set transistor;
the n-th first output reset transistor is electrically connected to the second node, the first electrode of the n-th first output reset transistor is electrically connected to the n-th driving output terminal, and the second electrode of the n-th first output reset transistor is electrically connected to the n-th output node;
the n-th second output reset transistor is electrically connected to the second node, the first electrode of the n-th second output reset transistor is electrically connected to the n-th output node, and the second electrode of the n-th second output reset transistor is electrically connected to the n-th second voltage terminal;
a gate of the n-th setting transistor is electrically connected to the n-th driving output terminal, the first electrode of the n-th setting transistor is electrically connected to the n-th output node, and the second electrode of the n-th setting transistor is electrically connected to the third voltage terminal.

12. The driving circuit according to claim 1, wherein the driving output circuit comprises an output transistor and an output reset transistor;
the gate of the output transistor is electrically connected to the first node, the first electrode of the output transistor is electrically connected to the first voltage terminal, and the second electrode of the output transistor is electrically connected to the N driving output terminals respectively;
the gate of the output reset transistor is electrically connected to the N driving output terminals, and the second electrode of the output reset transistor is electrically connected to the second voltage terminal.

13. The driving circuit according to any one of claims 1 to 5, wherein the first node control circuit is further electrically connected to the first clock signal terminal, an input terminal, a third node, a fourth voltage terminal, a fifth voltage terminal and a reset terminal, and is configured to control a connection between the first node and the fourth voltage terminal under a control of the first clock signal provided by the first clock signal terminal and the input signal provided by the input terminal, control the connection between the first node and the first clock signal terminal under the control of the reset signal provided by the reset terminal, and control the connection between the first node and the fifth voltage terminal under the control of the potential of the third node and the first clock signal.

14. The driving circuit according to any one of claims 1 to 5, wherein the first node control circuit is further electrically connected to an intermediate node, the first clock signal terminal, the input terminal, the third node, the fourth voltage terminal, the fifth voltage terminal and the reset terminal, and is configured to control the connection between the intermediate node and the fourth voltage terminal under the control of the first clock signal provided by the first clock signal terminal and the input signal provided by the input terminal, control the connection between the intermediate node and the first clock signal terminal under the control of the reset signal provided by the reset terminal, control the connection between the intermediate node and the fifth voltage terminal under the control of the potential of the third node and the first clock signal, and control the connection between the intermediate node and the first node under the control of the fourth voltage signal provided by the fourth voltage terminal.

15. The driving circuit according to any one of claims 1 to 5, wherein the driving circuit further comprises a third node control circuit and a carry output circuit;
the third node control circuit is electrically connected to the third node and is configured to control the potential of the third node;
the second node control circuit is further electrically connected to the third node, the first clock signal terminal, the first node, the fourth node and the fifth voltage terminal, respectively, and is configured to control the second node to be connected to the fourth node under the control of the first clock signal, control the fourth node to be connected to the second node under the control of the first clock signal, and control the second node to be connected to the fifth voltage terminal under the control of the potential of the first node;
the carry output circuit is electrically connected to the first node, the second node, the carry output terminal, the first voltage terminal and the fifth voltage terminal, respectively, and is configured to control the connection between the carry output terminal and the first voltage terminal under the control of the potential of the first node, and to control the connection between the carry output terminal and the fifth voltage terminal under the control of the potential of the second node.

16. The driving circuit according to claim 15, wherein the second node control circuit is further electrically connected to a reset terminal and a fourth voltage terminal, and is configured to control the connection between the second node and the fourth voltage terminal under the control of a reset signal provided by the reset terminal.

17. The driving circuit according to claim 15, wherein the third node control circuit is further electrically connected to the second clock signal terminal, the fourth voltage terminal, the input terminal, the fourth node and the fifth node, and is configured to control the connection between the third node and the fourth voltage terminal under the control of the second clock signal provided by the second clock signal terminal, control the connection between the third node and the fifth node under the control of the input signal provided by the input terminal, control the connection between the fifth node and the second clock signal terminal, control the connection between the fifth node and the fourth voltage terminal under the control of the potential of the third node, and control the potential of the third node according to the potential of the fourth node.

18. The driving circuit according to claim 13, wherein the first node control circuit comprises a first transistor, a second transistor, a third transistor, a fourth transistor and a fifth transistor;
a gate of the first transistor is the first clock signal terminal, the first electrode of the first transistor is electrically connected to the fourth voltage terminal, and the second electrode of the first transistor is electrically connected to the first electrode of the second transistor;
a gate of the second transistor is electrically connected to the input terminal, and the second electrode of the second transistor is electrically connected to the first node;
a gate of the third transistor is electrically connected to the third node, the first electrode of the third transistor is electrically connected to the first node, and the second electrode of the third transistor is electrically connected to the first electrode of the fourth transistor;
a gate of the fourth transistor is electrically connected to the first clock signal terminal, and the second electrode of the fourth transistor is electrically connected to the fifth voltage terminal;
a gate of the fifth transistor is electrically connected to the reset terminal, a first electrode of the fifth transistor is electrically connected to the first clock signal terminal, and a second electrode of the fifth transistor is electrically connected to the first node.

19. The driving circuit according to claim 14, wherein the first node control circuit comprises a first transistor, a second transistor, a third transistor, a fourth transistor, a fifth transistor and a sixth transistor;
a gate of the first transistor is electrically connected to the first clock signal terminal, the first electrode of the first transistor is electrically connected to the fourth voltage terminal, and the second electrode of the first transistor is electrically connected to the first electrode of the second transistor;
a gate of the second transistor is electrically connected to the input terminal, and the second electrode of the second transistor is electrically connected to the intermediate node;
a gate of the third transistor is electrically connected to the third node, the first electrode of the third transistor is electrically connected to the intermediate node, and the second electrode of the third transistor is electrically connected to the first electrode of the fourth transistor;
a gate of the fourth transistor is electrically connected to the first clock signal terminal, and the second electrode of the fourth transistor is electrically connected to the fifth voltage terminal;
a gate of the fifth transistor is electrically connected to the reset terminal, the first electrode of the fifth transistor is electrically connected to the first clock signal terminal, and the second electrode of the fifth transistor is electrically connected to the intermediate node.
a gate of the sixth transistor is electrically connected to the fourth voltage terminal, a first electrode of the sixth transistor is electrically connected to the intermediate node, and a second electrode of the sixth transistor is electrically connected to the first node.

20. The driving circuit according to claim 15, wherein the second node control circuit comprises a seventh transistor, an eighth transistor and a ninth transistor;
a gate of the seventh transistor is electrically connected to the third node, the first electrode of the seventh transistor is electrically connected to the first clock signal terminal, and the second electrode of the seventh transistor is electrically connected to the fourth node;
a gate of the eighth transistor is electrically connected to the first clock signal terminal, the first electrode of the eighth transistor is electrically connected to the fourth node, and the second electrode of the eighth transistor is electrically connected to the second node;
a gate of the ninth transistor is electrically connected to the first node, a first electrode of the ninth transistor is electrically connected to the second node, and a second electrode of the ninth transistor is electrically connected to the fifth voltage terminal.

21. The driving circuit according to claim 16, wherein the second node control circuit further comprises a tenth transistor;
a gate of the tenth transistor is electrically connected to the reset terminal, a first electrode of the tenth transistor is electrically connected to the second node, and a second electrode of the tenth transistor is electrically connected to the fourth voltage terminal.

22. The driving circuit according to claim 17, wherein the third node control circuit comprises an eleventh transistor, a twelfth transistor, a thirteenth transistor, a fourteenth transistor and a third capacitor;
a gate of the eleventh transistor is electrically connected to the second clock signal terminal, the first electrode of the eleventh transistor is electrically connected to the fourth voltage terminal, and the second electrode of the eleventh transistor is electrically connected to the third node;
a gate of the twelfth transistor is electrically connected to the input terminal, the first electrode of the twelfth transistor is electrically connected to the third node, and the second electrode of the twelfth transistor is electrically connected to the fifth node;
a gate of the thirteenth transistor is electrically connected to the input terminal, the first electrode of the thirteenth transistor is electrically connected to the fifth node, and the second electrode of the thirteenth transistor is electrically connected to the second clock signal terminal;
a gate of the fourteenth transistor is electrically connected to the third node, the first electrode of the fourteenth transistor is electrically connected to the fourth voltage terminal, and the second electrode of the fourteenth transistor is electrically connected to the fifth node;
a first electrode plate of the third capacitor is electrically connected to the third node, and the second electrode plate of the third capacitor is electrically connected to the fourth node.

23. The driving circuit according to claim 15, wherein the carry output circuit comprises a fifteenth transistor and a sixteenth transistor;
a gate of the fifteenth transistor is electrically connected to the first node, the first electrode of the fifteenth transistor is electrically connected to the first voltage terminal, and the second electrode of the fifteenth transistor is electrically connected to the carry output terminal;
a gate of the sixteenth transistor is electrically connected to the second node, a first electrode of the sixteenth transistor is electrically connected to the carry output terminal, and a second electrode of the sixteenth transistor is electrically connected to the fifth voltage terminal.

24. The driving circuit according to claim 6, wherein the first energy storage circuit comprises a first capacitor;
a first electrode plate of the first capacitor is electrically connected to the first node, and the second electrode plate of the first capacitor is electrically connected to one of the N driving output terminals.

25. The driving circuit according to claim 7, wherein the driving circuit comprises N first energy storage circuits, and the n-th first energy storage circuit comprises an n-th first capacitor;
the n-th first capacitor is electrically connected to the first node, and the second electrode plate of the n-th first capacitor is electrically connected to the n-th driving output terminal.

26. The driving circuit according to claim 8, wherein the second energy storage circuit comprises a second capacitor;
a first electrode plate of the second capacitor is electrically connected to the second node, and the second electrode plate of the second capacitor is electrically connected to the second terminal of one of the N output reset circuits.

27. The driving circuit according to claim 9, wherein the driving circuit comprises N second energy storage circuits; the n-th second energy storage circuit comprises an n-th second capacitor;
the n-th second capacitor is electrically connected to the second node, and the second electrode plate of the n-th second capacitor is electrically connected to the second terminal of the n-th output reset circuit.

28. A driving method, applied to the driving circuit according to any one of claims 1 to 27, comprising:
a first node control circuit controlling a potential of the first node;
a second node control circuit controlling a potential of the second node;
a driving output circuit controlling a n-th driving output terminal to output the n-th driving signal under the control of the potential of the first node and the potential of the second node;
wherein N is an integer greater than 1; n is a positive integer less than or equal to N.

29. A display substrate comprising the driving circuit according to any one of claims 1 to 27.

30. The display substrate according to claim 29, wherein the driving circuit comprises a second energy storage circuit; the second energy storage circuit is electrically connected to the second node, and the second energy storage circuit is configured to store electric energy; the second energy storage circuit comprises a second capacitor; and the display substrate further comprises N-1 pseudo capacitors;
the second capacitor and the N-1 pseudo capacitors are arranged along a first direction
the first electrode plate of the pseudo capacitor is electrically connected to the second electrode plate of the pseudo capacitor.

31. A display device comprising the driving circuit according to claim 28 or 29.
